# EUROPEAN PATENT APPLICATION

(11) **EP 4 102 944 A1**
(43) Date of publication of application: **14.12.2022**
(21) Application number: 21751491.8
(22) Date of filing: 05.01.2021
(51) Int. Cl.: H05K 7/20

(54) **COOLING PLATE AND MANUFACTURING METHOD THEREFOR**

(30) Priority: 03.02.2020 KR 20200012771
(71) Applicant: LS Electric Co., Ltd., Gyeonggi-do 14119 (KR)
(72) Inventor: KIM, Seongeon, Dongan-gu Gyeonggi-do 14118 (KR)
(74) Representative: K&L Gates LLP
(86) International application number: PCT/KR2021/000047
(87) International publication number: WO 2021/157873

(57) **Abstract**

Disclosed are a cooling plate and a manufacturing method therefor. The cooling plate according to an embodiment of the present invention comprises a cooling cover and a cooling body which has a cooling fluid accommodation portion formed therein and to which the cooling cover is coupled. The cooling cover is coupled to the cooling body so as to seal the cooling fluid accommodation portion. The cooling cover and the cooling body are coupled through friction stir welding. Thus, the cooling fluid accommodation portion can be reliably sealed.

## Description

### Technical Field

The present disclosure relates to a cooling plate and a method of manufacturing the cooling plate and, more particularly, to a cooling plate that is capable of minimizing deformation of respective shapes of a main body and a cover that constitute the cooling plate and a method of manufacturing the cooling plate.

### Background Art

A Flexible AC Transmission System (FACTS) or a New AC Transmission System) is a management technology for increasing flexibility of an electric power system by applying an electric power electronic control technology to an alternating electric power system.

Specifically, the FACTS is capable of controlling transmission power using a semiconductor switching element for electric power. The FACTS is capable of maximizing a utilization factor of a transmission line, increasing a transmission capacity, and minimizing voltage regulation.

In the FACTS, storage of electric power and input and output thereof are achieved by a capacitor element. The capacitor element is capable of being controlled by a switching element. Specifically, the switching element is capable of controlling inputting and outputting of electric power into and from the capacitor element, and the like.

Usually, the switching element includes an Insulated Gate Bipolar Transistor (IGBT) that is a semiconductor electric power element. When the FACTS operates, the IGBT is capable of computing a large amount of control information and controlling the capacitor element on the basis of the computed control information.

Therefore, as the FACTS operates for a longer time, the IGBT generates a larger amount of heat. Therefore, an appropriate operation of dissipating heat has to be performed in order to prevent the explosion of the IGBT due to overheat.

At this point, in a case where constituent elements for cooling the IGBT no longer communicate with each other due to vibration that occurs when a coolant flows or a sub-module operates, there is a concern that the sub-module will be damaged due to the coolant. Furthermore, there is also a risk that an accident, such as electric shock, will occur due to the coolant.

A modular cooling apparatus for high-voltage direct-current transmission system is disclosed in WIPO Publication No. WO 2015/099469. Specifically, the module cooling apparatus disclosed includes a through-hole and a louver plate that are formed in the vicinity of a heat sink provided on each of the modules that constitute the transmission system. Thus, outside air can flow through an internal space in the heat sink.

However, the above-mentioned patent document has a limitation in that it only proposes a method of preventing a coolant supplied to each of the modules from flowing to the outside. That is, the above-mentioned patent document does not propose a method of preventing a coolant from arbitrarily flowing out of an entire flow path, along which the coolant flows, to the outside.

Korean Patent Application Publication No. 10-2017-0022765 discloses a sub-module for a high-voltage battery. Specifically, the above-mentioned patent document discloses a battery sub-module having a structure in which frames provided on edges of a plurality of high-voltage battery cells are brought into contact with each other. With this structure, surfaces of the high-voltage battery cells are directly exposed to air, thereby being cooled.

However, the above-mentioned patent document discloses the air cooling-type battery sub-module instead of a water cooling-type sub-module that uses a coolant or the like and thus is not useful for the water cooling-type sub-module. That is, in the battery sub-module in the above-mentioned patent document, a problem associated with the arbitrary flowing of the coolant to the outside does not occur.

In addition, the two above-mentioned patent documents have a limitation in common in that they do not propose a method for stably supporting a constituent element for supplying the coolant.

### Disclosure of Invention

### Technical Problem

An object of the present disclosure is to provide a sub-module having a structure capable of solving the above-mentioned problems.

Another object of the present disclosure is to provide a cooling plate having a structure that is capable of sealing up a main body and a cover that constitute the cooling plate, without the risk of leakage, and a method of manufacturing the cooling plate.

Still another object of the present disclosure is to provide a cooling plate having a structure that does not require an additional member for coupling a main body and a cover that constitute the cooling plate and a method of manufacturing the cooling plate.

Still another object of the present disclosure is to provide a cooling plate having a structure that does not require an additional member for sealing up the cooling plate after a main body and a cover are coupled to each other and a method of manufacturing the cooling plate.

Still another object of the present disclosure is to provide a cooling plate having a structure in which distortion or the like cannot occur due to different coefficients of thermal expansion when a main body and a cover are coupled to each other and a method of manufacturing the cooling plate.

Still another object of the present disclosure is to provide a cooling plate having a structure that is capable of minimizing vortex flow of a fluid in an internal space after a main body and a cover are coupled to each other and a method of manufacturing the cooling plate.

Still another object of the present disclosure is to provide a cooling plate having a structure that is capable of minimize stress remaining after a main body and a cover are coupled to each other and a method of manufacturing the cooling plate.

### Solution to Problem

In order to achieve the above-mentioned objects, according to an aspect of the present disclosure, there is provided a cooling plate including: a cooling main body having a space formed inside; a cooling cover coupled to the cooling main body in such a manner as to seal up the space; and a cooling flow-path portion provided in any one of respective surfaces of the cooling cover and the cooling main body that face each other, and forming a flow path along which a coolant flows in the space, wherein the cooling main body and the cooling cover are coupled to each other by friction stir welding.

In the cooling plate, the cooling main body may include: a coolant accommodation portion formed by recessing a surface of one side of the cooling main body that is directed toward the cooling cover, and forming the space; and an inlet port and an outlet port that are formed in the cooling main body in a manner that passes therethrough, so that the coolant accommodation portion and the outside of the cooling main body communicate with each other, wherein the inlet port and the outlet port may communicate with the coolant accommodation portion.

In the cooling plate, the cooling flow-path portion may be provided in the cooling cover, an insertion protrusion may be provided by being formed on the coolant accommodation portion in a manner that protrudes therefrom toward the cooling cover, and a coupling through-hole may be provided by being formed in the cooling cover in a manner that passes therethrough, and may be configured in such a manner that the insertion protrusion is coupled to the coupling through-hole by being inserted thereinto.

In the cooling plate, the insertion protrusion may be formed in such a manner to extend in one direction, and the coupling through-hole may be formed in such a manner as to extend in the one direction.

In the cooling plate, the cooling flow-path portion may be provided in the cooling main body, a support protrusion may be provided by being formed on the coolant accommodation portion in a manner that protrudes therefrom toward the cooling cover, and, when the cooling cover is coupled to the coolant accommodation portion, a surface of one side of the cooling cover that is directed toward the coolant accommodation portion may be brought into contact with the support protrusion.

In the cooling plate, the cooling main body may include a coupling protrusion formed on a surface of one side of the support protrusion that is directed toward the cooling cover, in a manner that protrudes therefrom, and the coupling through-hole may be formed in the cooling cover in a manner that passes therethrough, and thus, when the cooling cover is coupled to the cooling main body, the coupling protrusion may be coupled to the coupling through-hole by being inserted thereinto.

In the cooling plate, the cooling main body may include a cover coupling portion surrounding the space, the coupled cooling cover being brought into contact with the cover coupling portion, the cooling cover may include a main-body coupling portion forming an outer edge of the cooling cover and brought into contact with the cover coupling portion, and the cover coupling portion and the main-body coupling portion may be heated at the same time and thus is joined to each other.

In the cooling plate, the cooling flow-path portion may include a flow-path protrusion formed in a manner that protrudes toward the other one of the respective surfaces of the cooling cover and the cooling main body that face each other, and formed in such a manner as to extend in one direction, a plurality of the flow-path protrusions may be provided and the plurality of the flow-path protrusions may be arranged to be spaced apart, and a flow-path recess along which the coolant flows may be formed in a space that is formed by arranging the plurality of the flow-path protrusion to be spaced apart.

In the cooling plate, an end portion of the flow-path protrusion that is directed toward the other one of the respective surfaces of the cooling cover and the cooling main body that face each other may be brought into contact with the other one of the respective surfaces of the cooling cover and the cooling main body that face each other.

In the cooling plate, the end portion of the flow-path protrusion that is directed toward the other one of the respective surfaces of the cooling cover and the cooling main body that face each other may be spaced apart a predetermined distance from the other one of the respective surfaces of the cooling cover and the cooling main body that face each other, and a seat member that is brought into contact with each of the end portion of the flow-path protrusion and the other one of the respective surfaces of the cooling cover and the cooling main body that face each other may be provided in a space that is formed by spacing the end portion of the flow-path protrusion apart the predetermined distance.

According to another aspect of the present disclosure, there is provided a method of manufacturing a cooling plate, the method including: a step of forming a cooling flow-path portion in any one of a cooling main body and a cooling cover coupled to the cooling main body; a step of arranging the cooling cover in such a manner as to cover the cooling main body; and a step of coupling respective portions of the cooling main body and the cooling cover that are brought into contact with each other, to each other, wherein the cooling main body and the cooling cover are coupled to each other by friction stir welding.

In the method, the step of forming the cooling flow-path portion in any one of the cooling main body and the cooling cover coupled to the cooling main body may include a step of forming a coolant accommodation portion in one surface of the cooling main body by recessing the one surface; and a step of forming a plurality of flow-path recesses in a surface in which the coolant accommodation portion is formed by recessing the one surface, by recessing the surface in such a manner that the plurality of flow-path recesses are spaced apart.

In the method, the step of arranging the cooling cover in such a manner as to cover the cooling main body may include a step of arranging a seat member in such a manner as to cover end portions of a plurality of flow-path protrusions each of which is formed between each of the plurality of flow-path recesses; a step of coupling a coupling protrusion formed on a support protrusion positioned on the coolant accommodation portion in the cooling main body in a manner that protrudes therefrom, to a coupling through-hole formed in the cooling cover in a manner that passes therefrom, by being inserted thereinto; and a step of performing gas shielded brazing treatment on the seat member and the end portions of the plurality of flow-path protrusions.

In the method, the step of forming the cooling flow-path portion in any one of the cooling main body and the cooling cover coupled to the cooling main body may include: a step of forming a plurality of flow-path recesses in one surface of the cooling cover by recessing the one surface in such a manner that the plurality of flow-path recesses are spaced apart; and a step of forming a coolant accommodation portion in one surface of the cooling main body by recessing the one surface.

In the method, the step of arranging the cooling cover in such a manner as to cover the cooling main body may include: a step of arranging a seat member in such a manner as to cover the cooling main body; a step of coupling an insertion protrusion positioned on the coolant accommodation portion in the cooling main body to a coupling through-hole formed in the cooling cover in a manner that passes therethrough, by being inserted thereinto; and a step of performing gas shielded brazing treatment on the seat member and the end portions of the plurality of flow-path protrusions each of which is formed between each of the plurality of flow-path recesses.

In the method, the step of coupling the respective portions of the cooling main body and the cooling cover that are brought into contact with each other, to each other may include: a step of bringing a cover coupling portion surrounding a coolant accommodation portion formed in the cooling main body by recessing and a main-body coupling portion forming an outer circumference of the cooling cover into contact with each other; and a step of heating the cover coupling portion and the main-body coupling portion at the same time and thus joining the cover coupling portion and the main-body coupling portion to each other.

The method may further include, after the step of coupling the respective portions of the cooling main body and the cooling cover that are brought into contact with each other, to each other, a step of removing a bead formed on respective portions of the cooling main body and the cooling cover that are brought into contact with each other; and a step of performing stress relief heat treatment on the cooling cover and the cooling main body, wherein the bead is removed by performing milling treatment thereon.

The method may further include, after the step of coupling the respective portions of the cooling main body and the cooling cover that are brought into contact with each other, to each other, a step of performing stress relief heat treatment on the cooling cover and the cooling main body.

### Advantageous Effects of Invention

According to the present disclosure, the following advantageous effects can be achieved.

First, a coolant accommodation portion that is a space where a coolant flows is formed inside a cooling main body. The cooling cover is coupled to the cooling main body in such a manner as to cover the coolant accommodation portion and thus to seal up the coolant accommodation portion.

Respective edge portions of the cooling main body and the cooling cover that meet are coupled to each other using a friction stir welding technique. That is, the respective edge portions are melted at the same time and thus joined to each other. Accordingly, the cooling main body and the cooling cover are coupled to each other.

Therefore, the coolant accommodation portion communicates with only an inlet port and an outlet port. Accordingly, the coolant flowing in the coolant accommodation portion does not arbitrarily flow to the outside.

In addition, as described above, the cooling main body and the cooling cover are coupled to each other using the friction stir welding technique. With the method described above, a cover coupling portion of the cooling main body and main-body coupling portion of the cooling cover are melted at the same time and thus joined and coupled to each other.

Therefore, a separate metal member or the like is not required in order to couple the cooling main body and the cooling cover.

In addition, as described above, the cooling main body and the cooling cover are coupled to each other using the friction stir welding technique. The cover coupling portion and the main-body coupling portion themselves are melted and thus joined to each other. Accordingly, the cooling main body and the cooling cover are coupled to each other.

Therefore, a separate member, such as an O-ring, for sealing up a gap between the cooling main body and the cooling cover is not required.

In addition, as described above, the cooling main body and the cooling cover are coupled to each other using the friction stir welding technique. The respective edge portions of the cooling main body and the cooling cover that meet are melted at the same time and thus joined and coupled to each other. The cooling main body and the cooling cover are formed of the same material, and thus have the same coefficient of thermal expansion.

Therefore, an additional member having a different coefficient of thermal expansion than the cooling main body and the cooling cover is not required in order to couple the cooling main body and the cooling cover to each other. Therefore, although the cooling main body and the cooling cover are coupled to each other, distortion thereof or the like does not occur.

In addition, a seat member may be provided between each of the end portions of flow-path protrusions forming a cooling flow-path portion and the cooling main body or the coolant. The seat member is melted using a gas shielded brazing technique, and thus the end portions of the flow-path protrusions and the cooling main body or the coolant may be coupled to each other.

Therefore, the end portions of the flow-path protrusions and the cooling main body or the coolant may be kept in contact with each other. Accordingly, pressure due to vortex flow of the coolant that occurs in a surplus space can be minimized.

In addition, as described above, the cooling main body and the cooling cover are formed of the same material and are coupled to each other using the friction stir welding technique. Accordingly, the cooling main body and the cooling cover have the same coefficient of thermal expansion, and thus stress occurring due to a welding operation can be minimized.

Furthermore, after the cooling main body and the cooling cover are coupled to each other, heat treatment is performed on a cooling plate in order to relieve the stress.

Therefore, after the cooling main body and the cooling cover are coupled to each other, the stress remaining the cooling plate can be minimized.

### Brief Description of Drawings

FIG. 1 is a perspective view illustrating a modular multilevel converter including a sub-module according to a first embodiment of the present disclosure.
FIG. 2 is a perspective view illustrating the sub-module according to the first embodiment of the present disclosure.
FIG. 3 is a perspective view illustrating a valve assembly provided in the sub-module in FIG. 2.
FIG. 4 is a partially exploded perspective view illustrating a relationship between the valve assembly in FIG. 3 and an explosion-free frame unit coupled to the valve assembly in FIG. 3.
FIG. 5 is an exploded perspective view illustrating the relationship between the valve assembly in FIG. 3 and an explosion-free frame unit coupled to the valve assembly in FIG. 3, when viewed from a different angle.
FIG. 6 is a schematic view illustrating a state where a cooling main body that is a first practical example of a cooling plate coupled to the valve assembly in FIG. 3 and a cooling cover are separated from each other.
FIG. 7 is a schematic view illustrating a state where a cooling main body that is a second practical example of the cooling plate coupled to the valve assembly in FIG. 3 and the cooling cover are separated from each other.
FIG. 8 is a cross-sectional view illustrating the state where the cooling main body that is the practical example of the cooling plate coupled to the valve assembly in FIG. 3 and the cooling cover are separated from each other.
FIG. 9 is a cross-sectional view illustrating the state where the cooling main body that is the second practical example of the cooling plate coupled to the valve assembly in FIG. 3 and the cooling cover are separated from each other.
FIG. 10 a conceptual view illustrating a seat member that is provided in the cooling plate according to the first embodiment of the present disclosure.
FIG. 11 is a conceptual view illustrating a state where the seat member is provided between the cooling man body and the cooling cover that are illustrated in FIG. 6 or 7.
FIG. 12 is a conceptual view illustrating a state where the cooling man body and the cooling cover that are illustrated in FIG. 6 or 7 are coupled to each other.
FIG. 13 is a flowchart illustrating a method of manufacturing a cooling plate according to a second embodiment of the present disclosure.
FIG. 14 is a flowchart illustrating a specific sub-step of Step S100 in FIG. 13.
FIG. 15 is a flowchart illustrating a specific sub-step of Step S200 in FIG. 13.
FIG. 16 is a flowchart illustrating a specific sub-step of Step S300 in FIG. 13.

### Mode for the Invention

A sub-module according to a first embodiment of the present disclosure will be described in detail below with reference to the accompanying drawings.

Descriptions of some constituent elements may be omitted below in order to clarify features of the present disclosure.

### 1. Definition of Terms

The term "electric current flow" used hereinafter means a state where an electrical signal, such as electric current, flows between two or more members. In a practical example, a state of the electric current flow may be retained by a wire or the like.

The term "communicating" used hereinafter means a state where two or more members are connected to each other in such a manner that a fluid possibly flows therebetween. In a practical example, a communicating state may be retained by a pipe or the like.

The term "coolant" used hereinafter means an arbitrary fluid that is capable of exchanging heat with another member. In a practical example, water may be used as the coolant.

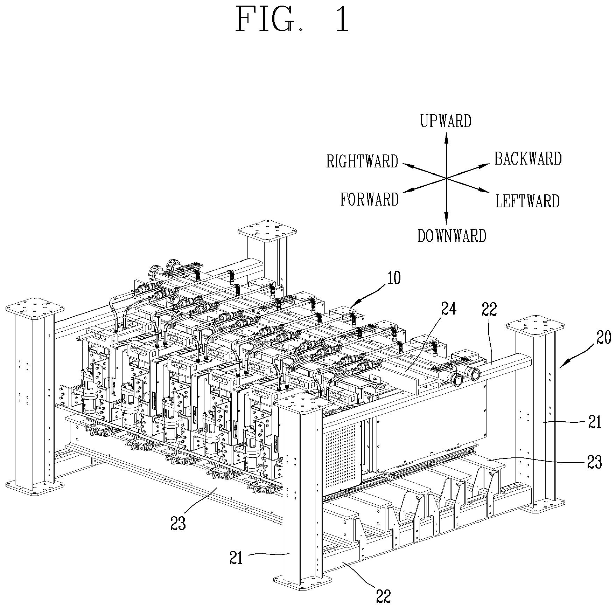

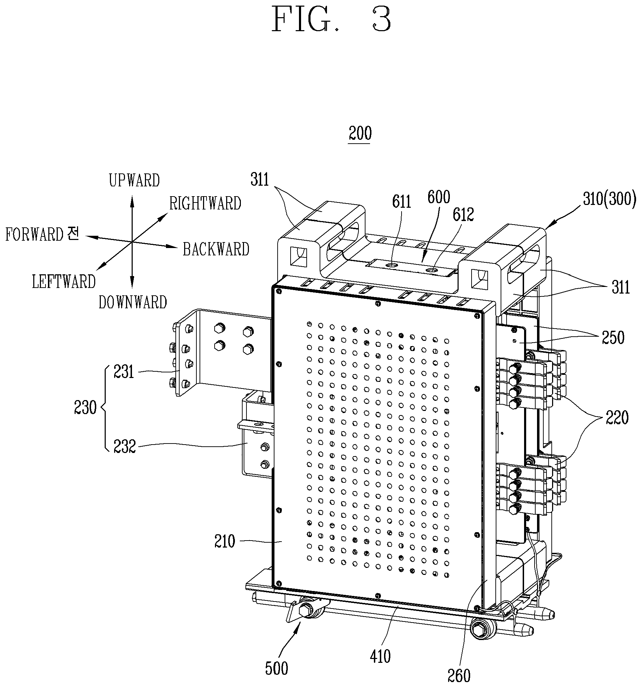

The means of the terms "front side," "rear side," "left side," "right side," "upper side," and "lower side" that will be used hereinafter would be understandable with reference to the coordinate system illustrated in FIGS. 1 and 3. That is, in the following description, a valve assembly 200 is assumed to be positioned to the front side of a capacitor assembly 100.

### 2. Description of a Configuration of a Modular Multilevel Converter 1 according to the First Embodiment of the Present Disclosure

A modular multilevel converter 1 according to the first embodiment of the present disclosure is illustrated in FIG. 1. The modular multilevel converter 1 may function as a Static Synchronous Compensator (STACOM).

That is, the modular multilevel converter 1 is a type of STACOM and performs a function of compensating for a loss voltage and thus increasing the stability of transmission and distribution when transmitting and distributing electricity or electric power.

The modular multiple-level converter 1 according to the first embodiment of the present disclosure includes a plurality of sub-modules 10 and a frame 20.

The sub-module 10 substantially performs a function of the above-mentioned modular multilevel converter 1. The plurality of the sub-modules 10 may be provided. The more the number of the provided sub-modules 10 is increased, the more the capacity of the modular multilevel converter 1 may be increased.

The sub-modules 10 are connected to each other in a manner that makes the electric current flow therebetween possible. In a practical example, the sub-modules 10 may be connected in series to each other.

In a practical example illustrated, a total of six sub-modules 10 are provided and are arranged to be spaced apart a predetermined distance in the leftward-rightward direction. The number of the provided sub-modules 10 may be changed.

The sub-modules 10 are supported by the frame 20. In the practical example illustrated, the sub-modules 10 are supported by the frame 20 forming one layer.

The frame 20 forms a main supporting structure of the modular multilevel converter 1. The frame 20 supports the sub-module 10 from the upper or lower side.

The sub-module 10 will be described in detail below.

The frame 20 may be formed of a material having high rigidity. In a practical example, the frame 20 may be formed of a steel material. In addition, the frame 20 is formed in such a manner as to have an I-shaped cross section. Thus, the rigidity in the axial direction of the frame 20 can be further enhanced.

A plurality of frames 20 may be provided. The plurality of frames 20 may be stacked on top of each other. The sub-modules 10 supported by the frame 20 may also be arranged in layers. Accordingly, the capacity of the modular multilevel converter 1 can be increased.

In a practical example illustrated, the frame 20 includes a vertical frame 21, a horizontal frame 22, a support 23, and a fixation frame 24.

The vertical frame 21 forms a main supporting structure in the upward-downward direction of the frame 20. The vertical frame 21 is formed in such a manner as to extend in the upward-downward direction. Coupling plates are provided on upper-side and lower-side end portions, respectively, of the vertical frame 21. The coupling plates provided in the shape of a rectangular plate. The coupling plate is supported on the ground or is coupled to another coupling plate on another frame 20 stacked vertically.

In the practical example illustrated, the vertical frames 21 are provided on the left-front, right-front, left-rear, right-rear sides, respectively. Accordingly, a total of four vertical frame 21 are provided. The number of the vertical frames 21 may be changed.

The vertical frame 21 is coupled to the horizontal frame 22. The horizontal frame 22 may be kept positioned at a preset angle by the vertical frame 21.

The horizontal frame 22 forms a main supporting structure in the forward-backward direction of the frame 20. The horizontal frame 22 is formed in such a manner as to extend in the forward-backward direction. A front-side end portion of the horizontal frame 22 is coupled to the vertical frame 21 that is arranged to the front side. A rear-side end portion of the horizontal frame 22 is coupled to the vertical frame 21 that is arranged to the rear side.

Accordingly, transformation in the forward-backward direction of the vertical frame 21 and deformation in the upward-downward direction of the horizontal frame 22 can be minimized.

In the practical example illustrated, the horizontal frames 22 are arranged to the left and right sides, respectively. Accordingly, a total of two horizontal frames 22 are arranged, but the number of the horizontal frames 22 may be changed.

The support 23 is coupled to the horizontal frame 22. The horizontal frame 22 supports left-side and right-side end portions of the support 23.

The support 23 supports the sub-module 10 from the lower side. The support 23 is coupled to the horizontal frame 22. Specifically, a left-side end portion of the support 23 is coupled to the horizontal frame 22 that is provided to the left side. A right-side end portion of the support 23 is coupled to the horizontal frame 22 that is provide to the right side.

The support 23 includes a plurality of beam members. The beam members each of which has an I-shaped cross section may be provided. The plurality of beam members are arranged to be spaced apart a predetermined distance side by side in the forward-backward direction.

The sub-module 10 is seated on the top of the support 23. As described below, a rail assembly 400 and a rail unit 420 are coupled to the top of the support 23 by being fixed thereto. In addition, a cart unit 410 of a sub-module 10 is coupled to the rail unit 420 in a manner that is slidable along the rail unit 420.

The fixation frame 24 extends at a predetermined angle with respect to the horizontal frame 22.

In a practical example, the fixation frame 24 may extend from the horizontal frame 22 on the left side to the horizontal frame 22 on the right side. In addition, in another practical example, the fixation frame 24 may extend vertically with respect to the horizontal frame 22.

3. Description of a Configuration of the Sub-module 10 according to the First Embodiment of the Present Disclosure

With reference to FIG. 1, the modular multilevel converter 1 according to the first embodiment of the present disclosure includes the sub-module 10. The sub-module 10 is provided in a modular way and may be added to the modular multilevel converter 1 or may be excluded therefrom.

That is, the number of the sub-modules 10 that are provided in the modular multilevel converter 1 may be changed. Accordingly, the capacity of the modular multilevel converter 1 may vary.

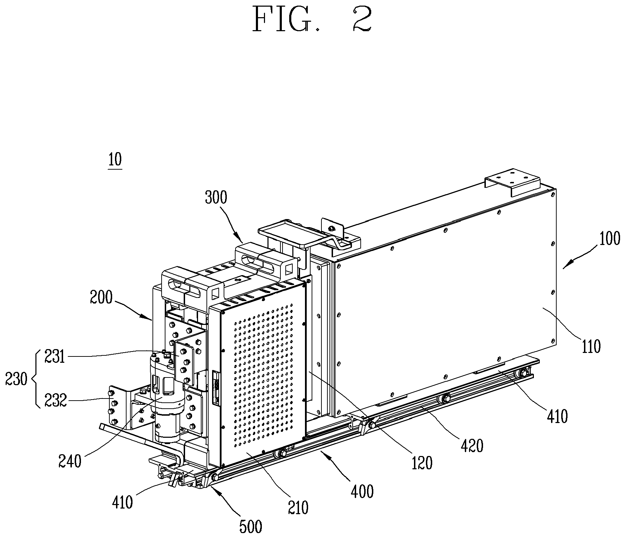

As illustrated in FIGS. 2 to 5, the sub-module 10 according to the first embodiment of the present disclosure includes the capacitor assembly 100, the valve assembly 200, an explosion-free frame unit 300, the rail assembly 400, a deviation prevention unit 500, and a cooling plate 600.

The constituent elements of the sub-module 10 according to the first embodiment of the present disclosure will be described in detail below with reference to the accompanying drawings. The cooling plate 600 will be described under a separate heading.

### (1) Description of the Capacitor Assembly 100

The capacitor assembly 100 includes a capacitor element (not illustrated) inside. The capacitor assembly 100 is connected to the valve assembly 200 in a manner that makes the electric current flow therebetween possible. The capacitor element (not illustrated) inside the capacitor assembly 100 may be charged or discharged by a switching operation that is performed by the valve assembly 200.

Accordingly, stored in the capacitor element (not illustrated) may be electric power energy that is to be input into the sub-module 10. The electric power energy stored in the capacitor element (not illustrated) may be used to drive each of the constituent elements of the sub-module 10.

In addition, the electric power energy may be supplied, as reactive power, to an outside electric power system to which the sub-module 10 is connected in a manner that makes the electric current flow therebetween possible.

In a practical example illustrated, the capacitor assembly 100 is connected to the rear side of the valve assembly 200. The reason for this is because a situation where the valve assembly 200 is repaired more frequently for maintenance than the capacitor assembly 100 occurs. That is, the reason for this is because only the valve assembly 200, as described below, may be easily separated to the front side.

The capacitor assembly 100 is supported by the rail assembly 400. Specifically, the capacitor assembly 100 is seated on the cart unit 410 of the rail assembly 400. In a practical example, the capacitor assembly 100 may be coupled to the cart unit 410 by being fixed thereto.

As described below, the cart unit 410 may be slid to the front side or the rear side along the rail unit 420. Accordingly, the capacitor assembly 100 may also be slid to the front side or the rear side, together with the cart unit 410.

In the practical example illustrated, the capacitor assembly 100 is formed in such a manner as to have a larger size than the valve assembly 200. The size of the capacitor assembly 100 depends on a size of the capacitor element (not illustrated) mounted inside the capacitor assembly 100. That is, the size of the capacitor assembly 100 may vary according to the size of the capacitor element (not illustrated).

The capacitor assembly 100 includes a capacitor housing 110 and a capacitor connector 120.

The capacitor housing 110 forms an exterior appearance of the capacitor assembly 100. The capacitor housing 110 has a predetermined space formed inside. The capacitor element (not illustrated) may be mounted in the predetermined space. The mounted capacitor element (not illustrated) is connected to the valve assembly 200 by the capacitor connector 120 in a manner that makes the electric current flow therebetween possible.

The capacitor housing 110 may be formed of a material having high rigidity. The reason for this is because the explosion of the capacitor element (not illustrated) accommodated inside the capacitor housing 100 due to an unexpected cause does not have any influence on the sub-module 10, the valve assembly 200, and the like.

The bottom of the capacitor housing 110 is coupled to the cart unit 410.

The front side of the capacitor housing 110 is connected to the valve assembly 200 by the capacitor connector 120 in a manner that makes the electric current flow therebetween possible.

The capacitor connector 120 connects the capacitor assembly 100 and the valve assembly 200 to each other in a manner that makes the electric current flow therebetween possible. The capacitor connector 120 is connected to the capacitor element (not illustrated) and a valve connector 220 of the valve assembly 200 in a manner that makes the electric current flow therebetween possible.

When one of the capacitor assembly 100 and the valve assembly 200 is slid toward the other thereof, the capacitor connector 120 may be coupled to the valve connector 220 by being slidably inserted thereinto. Accordingly, the state of the electric current flow between the capacitor connector 120 and the valve connector 220 is retained.

With the coupling technique described above, the state of the electric current flow between the capacitor assembly 100 and the valve assembly 200 may be easily retained or released.

In the practical example illustrated, the capacitor connector 120 is formed on one side, that is, the front side of the capacitor assembly 100 that is directed toward the valve assembly 200. The capacitor connector 120 is provided that is formed in the shape of a plate on the front side of the capacitor housing 110 in a manner that protrudes over a predetermined distance therefrom.

The capacitor connector 120 may have such an arbitrary shape that the capacitor connector 120 is coupled to the valve connector 220 in a manner that makes the electric current flow therebetween possible.

A plurality of capacitor connectors 120 may be provided. In the practical example illustrated, the capacitor connector 120 includes a first capacitor connector 121 that is provided to the left side and a second capacitor connector 122 that is provided to the right side.

The first capacitor connector 121 is slidably coupled to the valve connector 220 provided to the left side, in a manner that makes the electric current flow therebetween possible. In addition, the second capacitor connector 122 is slidably coupled to the valve connector 220 provided to the right side, in a manner that makes the electric current flow therebetween possible.

### (2) Description oof the Valve Assembly 200

The valve assembly 200 is a part of the sub-module 10 through which the sub-module 10 is connected to an outside power source or a load in a manner that makes the electric current flow therebetween possible. In addition, the valve assembly 200 is connected to the capacitor assembly 100 in a manner that makes the electric current flow therebetween possible, and the electric power energy may be input or output.

The valve assembly 200 may include a plurality of switching modules inside. In a practical example, the switching module may be included as an insulated gate bipolar transistor (IGBT) 330.

In addition, the valve assembly 200 may include a control board inside. The control board serves to control the switching module. In a practical example, the control board may be included as a printed circuit board (PCB).

In the practical example illustrated, the valve assembly 200 is positioned to the front side of the capacitor assembly 100. The reason for this is because the valve assembly 200 is repaired more frequently for maintenance than the capacitor assembly 100.

The valve assembly 200 is supported by the rail assembly 400. Specifically, the valve assembly 200 is seated on the cart unit 410 of the rail assembly 400. In a practical example, the valve assembly 200 may be coupled to the cart unit 410 by being fixed thereto.

As described below, the cart unit 410 may be slid to the front side or the rear side along the rail unit 420. Accordingly, the valve assembly 200 may also be slid to the front side or the rear side, together with the cart unit 410.

In the practical example illustrated, the valve assembly 200 includes a valve cover 210, the valve connector 220, an input busbar 230, a bypass switch 240, an output busbar 250, and an insulation housing 260.

The valve cover 210 forms a portion of an exterior appearance of the valve assembly 200. Specifically, the valve cover 210 forms left-side and right-side outer surfaces of the valve assembly 200.

The valve cover 210 is configured in such a manner as to cover the insulation housing 260. A printed circuit board and the like that are mounted inside the valve cover 210 are not arbitrarily exposed to the outside by the insulation housing 260.

With a fastening member, such as a screw, the valve cover 210 may be coupled to the insulation housing 260 by being fixed thereto.

The valve cover 210 is configured in such a manner as to ward off an electromagnetic noise component generated in the printed circuit board or in the IGBT 330. In a practical example, the valve cover 210 may be formed of aluminum (Al).

A plurality of through-holes are formed in the valve cover 210. The through-hole may communicate with an inner space in the insulation housing 260 and with the outside. Air is introduced through the through-hole and may cool the printed circuit board or the IGBT 330.

The valve cover 210 is connected to the cart unit 410 of the rail assembly 400 in a manner that makes the electric current flow therebetween possible. Accordingly, the valve cover 210 is grounded, and thus an unnecessary electric current flow may not occur.

A direction from the valve cover 210 toward the explosion-free frame unit 300 may be defined as an "inward direction." In addition, a direction from the explosion-free frame unit 300 toward the valve cover 210 may be defined as an "outward direction."

The insulation housing 260 is positioned in the inward direction of the valve cover 210.

The valve connector 220 connects the valve assembly 200 and the capacitor assembly 100 to each other in a manner that makes the electric current flow therebetween possible. The valve connector 220 is positioned on one side of the valve assembly 200 that is directed toward the capacitor assembly 100, that is, on the rear side thereof in the practical example illustrated.

The valve connector 220 is formed in such a manner as to extend one direction, that is, in the forward-backward direction in the practical example illustrated.

One side of the valve connector 220, that is, the front side thereof in a practical example illustrated, is connected to the output busbar 250 in a manner that makes the electric current flow therebetween possible. In the practical example illustrated, the one side of the valve connector 220 is coupled to the output busbar 250 in a screw-fastened manner.

The other side of the valve connector 220, that is, the rear side thereof in a practical example illustrated is connected to the capacitor connector 120 in a manner that makes the electric current flow therebetween possible.

The valve connector 220 may be configured with one pair of plate members that are arranged to be spaced apart a predetermined distance. That is, in a practical example illustrated, the valve connectors 220 are provided in the outward direction and the inward direction, respectively, and are arranged in such a manner as to face each other.

The capacitor connector 120 may be slidably inserted into or removed from a space that is formed by the one pair of plate members being arranged to be spaced apart the predetermined distance.

An end portion of one side of each of the plate members in one pair that is directed toward the capacitor assembly 100, that is, an end portion of the rear side thereof in a practical example illustrated is formed in such a manner as to be rounded in the outward direction. Accordingly, the coupling and removing in a slidable manner may be easily performed.

Each of the plate members in one pair may include a plurality of bar members. In the practical example illustrated, the plate members in one pair includes four bar members formed to be stacked on top of each other in the upward-downward direction. The number of the bar members may be changed.

A plurality of valve connectors 220 may be provided. In the practical example illustrated, two valve connectors 220 are arranged to be spaced apart a predetermined distance in the upward-downward direction. In addition, the two valve connectors 220 are provided to each of the two output busbars 250 provided. Thus, a total of four valve connectors 220 are provided.

The number of the valve connectors 220 may be arbitrarily changed in such a manner that the state of the electric current flow between the valve assembly 200 and the capacitor assembly 100 is retained.

The input busbar 230 connects the sub-module 10 to an outside power source or a load in a manner that makes the electric current flow therebetween possible.

In the practical example illustrated, the input busbar 230 is formed in such a manner as to extend over a predetermined distance to the front side of the explosion-free frame unit 300. The front side of the input busbar 230 is connected to the outside power source or the load in a manner that makes the electric current flow therebetween possible. The front side of the input busbar 230 is connected to the bypass switch 240 in a manner that makes the electric current flow therebetween possible.

In addition, the rear side of the input busbar 230 is connected to an electric-current-flow busbar 320 in a manner that makes the electric current flow therebetween possible.

A plurality of input busbars 230 may be provided. In the practical example illustrated, the input busbar 230 includes a first input busbar 231 positioned to the upper side and a second input busbar 232 positioned to the lower side.

The first input busbar 231 is connected to a first electric-current-flow busbar 321 in a manner that makes the electric current flow therebetween possible. Accordingly, the first input busbar 231 is connected to a first IGBT 331 in a manner that makes the electric current flow therebetween possible.

The second input busbar 232 is connected to a second electric-current-flow busbar 322 in a manner that makes the electric current flow therebetween possible. Accordingly, the second input busbar 232 is connected to a second IGBT 332 in a manner that makes the electric current flow therebetween possible.

Each of the first input busbar 231 and the second input busbar 232 is connected to the outside power supply and the load in a manner that makes the electric current flow therebetween possible. In addition, each of the first input busbar 231 and the second input busbar 232 is connected to the bypass switch 240 in a manner that makes the electric current flow therebetween possible.

The bypass switch 240 is configured in such a manner that the sub-module 10 is excluded from the modular multilevel converter 1 in a case where a problem occurs in a constituent element of an arbitrary sub-module 10.

Specifically, the bypass switch 240 may electrically short-circuit the first input busbar 231 and the second input busbar 232 of the sub-module 10. Accordingly, electric current flowing into one of the first input busbar 231 and the second input busbar 232 of the sub-module 10 flows out through the other one thereof.

Accordingly, the sub-module 10 functions as a wire and may be electrically excluded from the modular multilevel converter 1.

The bypass switch 240 is positioned, to the front side of the explosion-free frame unit 300, between the first input busbar 231 and the second input busbar 232. The bypass switch 240 is connected to each of the first input busbar 231 and the second input busbar 232 in a manner that makes the electric current flow therebetween possible.

The output busbar 250 connects the IGBT 330 and the capacitor assembly 100 to each other in a manner that makes the electric current flow therebetween possible.

In the practical example illustrated, the output busbar 250 is formed in such a manner as to extend over a predetermined distance in a direction toward the capacitor assembly 100, that is, to the rear side. The valve connector 220 is coupled to the rear side of the output busbar 250 in a manner that makes the electric current flow therebetween possible. In a practical example, the valve connector 220 may be coupled to the output busbar 250 in a screw-fastened manner.

The rear side of the output busbar 250 may be connected to the electric-current-flow busbar 320, which is connected to the IGBT 330 in a manner that makes the electric current flow therebetween possible, in a manner that makes the electric current flow therebetween possible.

A plurality of output busbars 250 may be provided. In the practical example illustrated, two output busbars 250 are provided and are arranged to be spaced apart a predetermined distance. The predetermined distance may be the same as a distance that the first capacitor connector 121 and the second capacitor connector 122 are spaced apart.

The insulation housing 260 accommodates a printed circuit board inside. In addition, the insulation housing 260 is brought into contact with the electric-current-flow busbar 320 in a manner that makes the electric current flow therebetween possible and thus is connected to each of the printed circuit board and the IGBT 330 in a manner that makes the electric current flow therebetween possible. Accordingly, the IGBT 330 may operate according to a control signal computed in the printed circuit board.

A plurality of insulation housings 260 may be provided. In the practical example illustrated, two insulation housings 260 are provided, one on the left side of the explosion-free frame unit 300 and the other one on the right side thereof.

One side in the outward direction of the insulation housing 260, that is, one side in a direction opposite to the explosion-free frame unit 300 may be shielded by the valve cover 210. In the practical example illustrated, the valve covers 210 is provided on each of the left side of the insulation housing 260 that is positioned to the left side and the right side of the insulation housing 260 that is positioned to the right side.

The insulation housing 260 may ward off the electromagnetic noise generated by the printed circuit board or the IGBT 330. The insulation housing 260 may be formed of aluminum (Al).

Therefore, the electromagnetic noise generated by the printed circuit board or the IGBT 330 does not arbitrarily propagate to the outside by the valve cover 210 and the insulation housing 260.

The insulation housing 260 has a predetermined space formed inside. An insulation layer 270 and a printed circuit board are positioned in the predetermined space.

The insulation housing 260 may be formed of a conductive material. Accordingly, the electromagnetic noise generated by the printed circuit board accommodated inside the insulation housing 260 may be ground via an outside resistor through the insulation housing 260. Likewise, the electromagnetic noise generated by the IGBT 330 provided adjacent to the insulating housing 260 may also be ground via an outside resistor through the insulation housing 260.

### (3) Description of the Explosion-free Frame Unit 300

The sub-module 10 according to the first embodiment of the present disclosure includes the explosion-free frame unit 300. The explosion-free frame unit 300 may accommodate a switching element, such as the IGBT 330, inside.

In addition, in a case where the accommodated IGBT 330 is exploded, the explosion-free frame unit 300 according to the first embodiment of the present disclosure may prevent damage to the adjacent IGBT 330. Furthermore, the explosion-free frame unit 300 according to the first embodiment of the present disclosure is formed in such a manner that gas and the like occurring due to the explosion can be easily discharged.

As illustrated in FIGS. 2 to 5, the explosion-free frame unit 300 may be provided to the valve assembly 200. The reason for this is because the IGBT 330 functioning as a switching element is provided to the valve assembly 200.

The reason for this would also be understandable from the fact that the explosion-free frame unit 300 is included in the valve assembly 200.

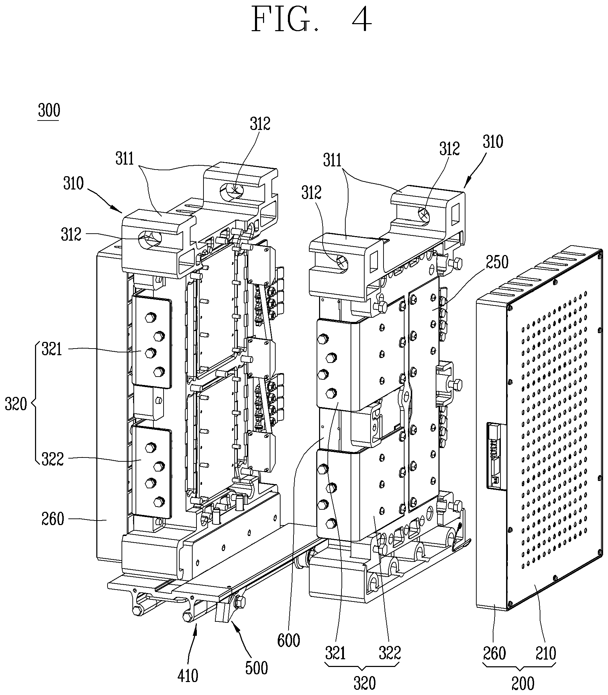

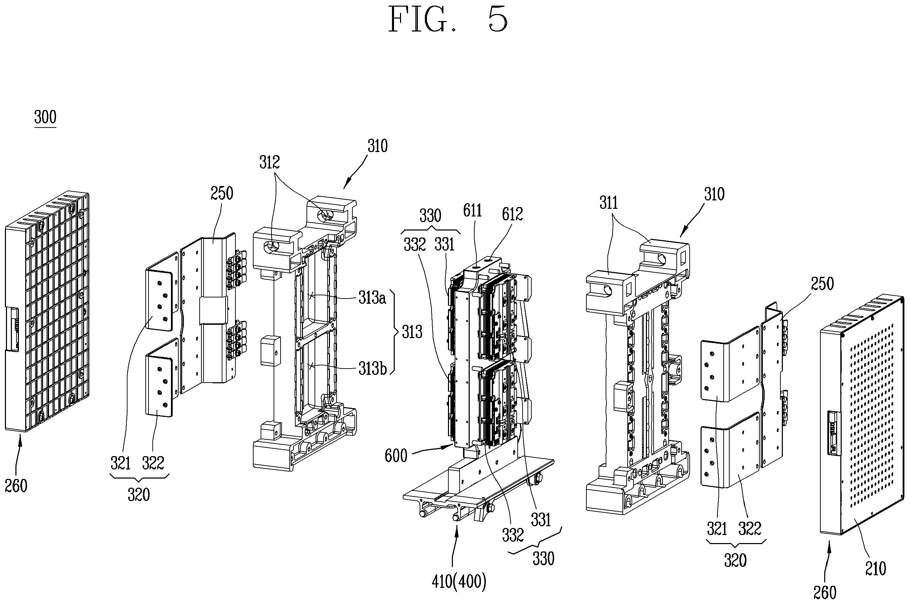

The explosion-free frame unit 300 according to the first embodiment of the present disclosure will be described in detail below with reference to FIGS. 4 and 5.

In the practical example illustrated, the explosion-free frame unit 300 includes a casing unit 310, the electric-current-flow busbar 320, and the IGBT 330.

The casing unit 310 forms an exterior appearance of the explosion-free frame unit 300. The electric-current-flow busbar 320 and the cooling plate 600 are coupled to the casing unit 310.

The casing unit 310 has a predetermined space formed inside. The IGBT 330 may be accommodated in the predetermined space.

The insulation housing 260 may be coupled to one side in the outward direction of the casing unit 310, that is, to one side in a direction opposite to the cooling plate 600.

A plurality of casing units 310 may be provided. In the practical example illustrated, two casing units 310 are provided. The casing units 310 may be formed in such a manner as to be symmetrical in shape. One casing unit 310 will be described below. It would be understandable that the other casing unit 310 also has the same structure as the one casing unit 310.

The casing units 310 are coupled to each other in such a manner to form a predetermined space therebetween. The IGBT 330 and the cooling plate 600 are positioned in the predetermined space.

The electric-current-flow busbar 320 is coupled in the outward direction of the casing unit 310, that is, in a direction toward the valve cover 210. The electric-current-flow busbar 320 is positioned between the casing unit 310 and the insulation housing 260.

The cooling plate 600 may be coupled in the inward direction of the casing unit 310, that is, in a direction in which the casing units 310 face each other. That is, the cooling plate 600 is positioned between the casing units 310.

The IGBT 330 is positioned in the inward direction of the casing unit 310, that is, in a direction toward the cooling plate 600. That is, the IGBT 330 is positioned between the casing unit 310 and the cooling plate 600.

A fastening member (not illustrated) may be provided to couple the casing unit 310, the electric-current-flow busbar 320, and the IGBT 330 to the cooling plate 600.

In addition, the casing unit 310, the insulation housing 260, and the valve cover 210 may also be coupled to each other with a fastening member (not illustrated).

In a practical example, the fastening member (not illustrated) may be provided as a screw.

The casing unit 310 may be formed of an insulation material. In addition, the casing unit 310 may be formed of a heat-resistant, pressure-resistant and wear-resistant material. In a practical example, the casing unit 310 may be formed of a synthetic resin.

In the practical example illustrated, the casing unit 310 is formed in such a manner as to extend in the upward-downward direction. The reason for this is because a plurality of IGBTs 330 are provided and are arranged in the upward-downward direction.

The casing unit 310 includes a protrusion 311 and a grounding bar through-hole 312. In addition, an IGBT accommodation space (not illustrated) is formed inside the casing unit 310, and the IGBT 330 may be accommodated therein.

The protrusion 311 may be formed in such a manner as to protrude from the top of a casing frame 310a. A plurality of protrusions 311 may be formed. The plurality of protrusions 311 may be formed in such a manner as to be spaced apart a predetermined distance.

In the practical example illustrated, the protrusion 311 is formed in such a manner as to protrude upward from the front side and the rear side of the top of the casing frame 310a. The protrusions 311 may be positioned on the same line in the forward-backward direction.

The grounding bar through-hole 312 is formed in the protrusion 311 in a manner that passes therethrough.

A grounding bar unit (not illustrated) is coupled to the grounding bar through-hole 312 in a manner that passes therethrough. The grounding bar through-hole 312 is formed in the protrusion 311 in a manner that passes therethrough. In the practical example illustrated, the grounding bar through-hole 312 is formed in a manner that passes through the protrusion 311 in the forward-backward direction.

The grounding bar through-hole 312 may be formed in such a manner as to correspond to a shape of the grounding bar unit (not illustrated). In the practical example illustrated, the grounding bar unit (not illustrated) has the shape of a cylinder, and thus the grounding bar through-hole 312 may be formed in such a manner as to have a cylindrical cross section.

As described above, the protrusion 311 may be formed on each of the front side and the rear side. The grounding bar through-hole 312 may be formed in each of the plurality of protrusions 311.

The grounding bar through-holes 312 may be formed in the protrusions 311, respectively, in such a manner as to have the same central axis. In addition, the grounding bar through-hole 312 may be formed in such a manner as to have the same central axis as a grounding protrusion (not illustrated).

The IGBT accommodation space (not illustrated) accommodates the IGBT 330. The IGBT accommodation space (not illustrated) may be defined as a predetermined space formed inside the casing unit 310. The IGBT accommodation space (not illustrated) is formed by recessing one side of the casing unit 310 that is directed toward the cooling plate 600, by a predetermined distance therefrom.

A plurality of IGBT accommodation spaces (not illustrated) may be formed. In the practical example illustrated, the IGBT accommodation space (not illustrated) includes a first IGBT accommodation space and a second IGBT accommodation space. The first IGBT accommodation space is formed to one side of the IGBT accommodation space that is directed toward the protrusion 311. The second IGBT accommodation space is formed to the other side of the IGBT accommodation space that is opposite in direction to the protrusion 311.

The reason for this is because the IGBT 330, including two IGBT, that is, the first IGBT 331 and the second IGBT 332, is provided. That is, the first IGBT 331 is accommodated in the first IGBT accommodation space, and the second IGBT 332 is accommodated in the second IGBT accommodation space.

As described above, two casing units 310 are provided and are coupled to each other. Two IGBT accommodation spaces (not illustrated) are formed in one the casing unit 310. From this, it would be understandable that a total of four IGBTs 330 are accommodated in each of the explosion-free frame units 300.

A shape of each of the IGBT accommodation spaces may be determined in a manner that corresponds to a shape of each of the first and second IGBTs 331 and 332. In addition, the first IGBT accommodation space and the second IGBT accommodation space may be formed in such a manner that shapes thereof correspond to each other.

A partition wall is formed between the first IGBT accommodation space and the second IGBT accommodation space. When the casing unit 310 and the cooling plate 600 are coupled to each other, a surface of one side of the partition that is directed toward the cooling plate 600 is brought into contact with the cooling plate 600.

The electric-current-flow busbar 320 transfers electric current transferred to the valve assembly 200 to the capacitor assembly 100. In addition, the electric-current-flow busbar 320 connects the printed circuit board and the IGBT 330 to each other in a manner that makes the electric current flow therebetween possible.

The electric-current-flow busbar 320 is connected to the input busbar 230 in a manner that makes the electric current flow therebetween possible. Electric power energy transferred to the input busbar 230 may be transferred to the electric-current-flow busbar 320.

The electric-current-flow busbar 320 is connected to the output busbar 250 in a manner that makes the electric current flow therebetween possible. The electric power energy transferred to the electric-current-flow busbar 320 is transferred to the output busbar 250.

The electric-current-flow busbar 320 is connected to each of the printed circuit board and the IGBT 330 in a manner that makes the electric current flow therebetween possible. The control signal computed in the printed circuit board and the IGBT 330 may be transferred to another constituent element.

The electric-current-flow busbar 320 includes the first electric-current-flow busbar 321 and the second electric-current-flow busbar 322.

The first electric-current-flow busbar 321 is positioned to the upper side of the second electric-current-flow busbar 322 and is connected to each of the first input busbar 231 and the output busbar 250 in a manner that makes the electric current flow therebetween possible. The second electric-current-flow busbar 322 is positioned to the lower side of the first electric-current-flow busbar 321 and is connected to each of the second input busbar 232 and the output busbar 250 in a manner that makes the electric current flow therebetween possible.

In the practical example illustrated, the electric-current-flow busbar 320 is positioned between the casing unit 310 and the insulation housing 260.

The electric-current-flow busbar 320 is formed in such a manner as to extend in one direction, that is, in the forward-backward direction in the practical example illustrated. End portions in the one direction of both sides of the electric-current-flow busbar 320, that is, the front-side end portion and the rear-side end portion extend at a predetermined angle toward the casing unit 310. In a practical example, the predetermined angle may be a right angle.

When the electric-current-flow busbar 320 is coupled to the casing unit 310, the electric-current-flow busbar 320 surrounds the front side, the left or right side, and the rear side of the casing unit 310.

The electric-current-flow busbar 320 may be formed of an electrically conductive material. In addition, the electric-current-flow busbar 320 may be formed of a material having high rigidity. In a practical example, the electric-current-flow busbar 320 may be formed of a material containing iron.

Therefore, even in a case where the IGBT 330 accommodated in the IGBT accommodation space (not illustrated) is exploded, damage to the casing unit 310 or shape deformation thereof can be minimized by the electric-current-flow busbar 320 surrounding the casing unit 310.

In a practical example, the casing unit 310, the electric-current-flow busbar 320, the insulation housing 260, and the cooling plate 600 may be coupled to each other in a screw-fastened manner.

The IGBT 330 controls electric current that flows into or flow out of the sub-module 10. In a practical example, the IGBT 330 may function as a switching element.

The IGBT 330 is accommodated in the IGBT accommodation space (not illustrated). The IGBT 330 may be brought into contact with a surface of the cooling plate 600.

Specifically, respective surfaces of the cooling plate 600 and the IGBT 330 that are directed toward may be brought into contact with each other. Accordingly, heat generated in the IGBT 330 may propagate to the cooling plate 600, and thus the IGBT 330 may be cooled.

The IGBT 330 is connected to the electric-current-flow busbar 320 in a manner that makes the electric current flow therebetween possible. Electric power energy for operating the IGBT 330 may be transferred through the electric-current-flow busbar 320.

In addition, the control signal computed by the IGBT 330 may be transferred to another constituent element, for example, a printed circuit board, a capacitor element (not illustrated), or the like through the electric-current-flow busbar 320.

A plurality of IGBTs 330 may be provided. In the practical example illustrated, the IGBT 330 includes a first IGBT 330 and a second the IGBT 330. The first IGBT 330 is arranged to the upper side in a direction toward the protrusion 311, and the second the IGBT 330 is arranged to the lower side in a direction opposite to the protrusion 311.

As described above, two casing units 310 may be provided. Accordingly, in the practical example illustrated, two IGBTs 330 are provided to each of the casing units 310 to the left and right sides, and thus a total of four IGBTs 330 are provided.

### (4) Description of the Rail Assembly 400 according to the First Embodiment of the Present Disclosure

The sub-module 10 according to the first embodiment of the present disclosure includes the rail assembly 400. The rail assembly 400 slidably supports the valve assembly 200 and the capacitor assembly 100.

In addition, the rail assembly 400 according to the first embodiment of the present disclosure is configured in such a manner as to prevent that the valve assembly 200 and the capacitor assembly 100 from deviating arbitrarily.

The rail assembly 400 according to the first embodiment of the present disclosure will be described in detail below with reference to FIGS. 2 to 5.

In the practical example illustrated, the rail assembly 400 includes the cart unit 410 and the rail unit 420.

The cart unit 410 slidably supports the capacitor assembly 100 and the valve assembly 200. The cart unit 410 supports the capacitor assembly 100 and the valve assembly 200 from the lower side.

The capacitor assembly 100 and the valve assembly 200 may be slid toward the front side or the rear side, together with the cart unit 410, in a state of being seated on the cart unit 410.

Each of the capacitor assembly 100 and the valve assembly 200 may be coupled to the cart unit 410 with separate fastening members (not illustrated).

A plurality of cart units 410 may be provided. The plurality of cart units 410 may support the capacitor assembly 100 and the valve assembly 200, respectively.

The cart unit 410 is slidably coupled to the rail unit 420. The cart unit 410 may be slid toward the front side and the rear side along the rail unit 420.

The cart unit 410 is formed in such a manner as to extend in a direction in which the capacitor assembly 100 and the valve assembly 200 are connected to each other, that is, in the forward-backward direction in the practical example illustrated.

A distance over which the cart unit 410 extends may be determined by each of the lengths in the forward-backward direction of the capacitor assembly 100 and the valve assembly 200. Therefore, the cart units 410 may extend over different distances.

### (5) Description of the Deviation Prevention Unit 500 according to the First Embodiment of the Present Disclosure

The sub-module 10 according to the first embodiment of the present disclosure includes the deviation prevention unit 500. The deviation prevention unit 500 prevents the cart unit 410, on which the capacitor assembly 100 or the valve assembly 200 is seated, from arbitrarily deviating from the rail unit 420.

In a practical example illustrated, the deviation prevention unit 500 is rotatably coupled to the cart unit 410. The deviation prevention unit 500 is slid, together with the cart unit 410, in a state of being brought into contact with the rail unit 420.

In addition, the deviation prevention unit 500 may also be provided to the rail unit 420. In the above-mentioned practical example, the deviation prevention unit 500 may be formed, as a groove, by recessing a surface of one side of the cart unit 410 that is directed toward the rail unit 420, by a predetermined distance therefrom.

As the cart unit 410 is slid, the deviation prevention unit 500 rotatably coupled to the cart unit 410 is also moved. When the cart unit 410 is moved close to the deviation prevention unit 500 provided to the rail unit 420, the deviation prevention unit 500 provided to the cart unit 410 is inserted into the deviation prevention unit 500 provided to the rail unit 420.

Accordingly, the cart unit 410 is not moved toward an end portion of the rail unit 420. With the above-described structure, the cart unit 410 may not arbitrarily deviate from the rail unit 420.

### 4. Description of the Cooling Plate 600 according to the First Embodiment of the Present Disclosure

The sub-module 10 according to the first embodiment of the present disclosure includes the cooling plate 600. The cooling plate 600 is configured in such a manner as to exchanges heat with the IGBT 330 and thus cool the IGBT 330. In a practical example, the cooling plate 600 may be brought into contact with a surface of the IGBT 330.

The cooling plate 600 according to the first embodiment of the present disclosure will be described in detail below with reference to FIGS. 5 to 12.

The cooling plate 600 is coupled to the explosion-free frame unit 300. Specifically, the cooling plate 600 is positioned between each of the plurality of casing units 310, and is coupled to the plurality of casing units 310.

In the practical example illustrated, the cooling plate 600 is formed in such a manner that a length in the upward-downward direction thereof is greater than a length in the forward-backward direction thereof. The reason for this is because the cooling plate 600 may cool at the same time the first IGBT 331 and the second IGBT 332 that are arranged in the upward-downward direction.

In the practical example illustrated, the cooling plate 600 having the shape of a cuboid is provided. The cooling plate 600 may have such an arbitrary shape that the cooling plate 600 is brought into contact with the IGBT 330 and thus cools the IGBT 330.

The cooling plate 600 may be formed of a material having high thermal conductivity. In a practical example, the cooling plate 600 may be formed of aluminum (Al).

In the practical example illustrated, the cooling plate 600 includes a cooling main body 610, a cooling cover 620, a cooling flow-path portion 630, a separation portion 640, and a seat member 650.

The cooling main body 610 forms an exterior appearance of the cooling plate 600. In the practical example illustrated, the cooling main body 610, formed in the shape of a plate in such a manner that a length in the upward-downward direction thereof is greater than a length in the forward-backward direction thereof, is provided. A shape of the cooling main body 610 may be changed.

A predetermined space is formed inside the cooling main body 610. The predetermined space communicates with the outside. A fluid flowing from the outside may flow in the predetermined space inside the cooling main body 610 and then may flow out of the cooling main body 610.

The cooling main body 610 is brought into contact with the IGBT 330 and thus exchanges heat therewith A coolant flowing inside the cooling main body 610 may pick up heat from the IGBT 330 and may expel the heat out of the cooling main body 610.

The cooling main body 610 communicates with the outside. The cooling main body 610 communicates with an outside through the inlet port 611 and an outlet port 612.

The cooling main body 610 includes the inlet port 611, the outlet port 612, a coolant accommodation portion 613, an insertion protrusion 614, a support protrusion 615, a coupling protrusion 616, and a cover coupling portion 617.

The inlet port 611 communicates with the inside and the outside of the cooling main body 610. Through the inlet port 611, the coolant supplied from the outside may flow into the cooling main body 610. In a practical example, the inlet port 611 may be formed in the cooling main body 610 in a manner that passes therethrough.

The inlet port 611 communicates with the coolant accommodation portion 613. The coolant, after flowing through the inlet port 611, may flow into the coolant accommodation portion 613.

In the practical example illustrated, the inlet port 611 is positioned in the top of the cooling main body 610. In addition, the inlet port 611 is positioned to the front side of the outlet port 612. The inlet port 611 may be formed at an arbitrary position on the top of the cooling main body 610 at which the inlet port 611 may communicate with the inside and the outside of the cooling main body 610.

The outlet port 612 communicates with the inside and the outside of the cooling main body 610. Through the outlet port 612, the coolant may circulate through a space inside the cooling main body 610, and the coolant, after exchanging heat with the IGBT 330, may flow out of the cooling main body 610. In a practical example, the outlet port 612 may be formed in the cooling main body 610 in a manner that passes therethrough.

The outlet port 612 communicates with the coolant accommodation portion 613. The coolant, after flowing in the coolant accommodation portion 613, may flow to the outside through the outlet port 612.

In the practical example illustrated, the outlet port 612 is positioned in the top of the cooling main body 610. In addition, the outlet port 612 is positioned to the rear side of the inlet port 611. The outlet port 612 may be formed at an arbitrary position on the top of the cooling main body 610 at which the outlet port 612 may communicate with the inside and the outside of the cooling main body 610.

The coolant accommodation portion 613 is a space in which the coolant flows after flowing into the cooling main body 610 through the inlet port 611. The coolant accommodation portion 613 communicates with the inlet port 611. The coolant flowing from the outside may flow in the coolant accommodation portion 613 and may exchange heat with the IGBT 330.

The coolant accommodation portion 613 is formed by recessing a surface of one side of the cooling main body 610, by a predetermined distance therefrom. Specifically, the coolant accommodation portion 613 is formed by recessing a surface of one side of the cooling main body 610 that is directed toward the cooling cover 620, by a predetermined distance therefrom.

The coolant, after exchanging heat while flowing in the coolant accommodation portion 613, may flow out of the cooling main body 610 through the outlet port 612. The coolant accommodation portion 613 communicates with the outlet port 612.

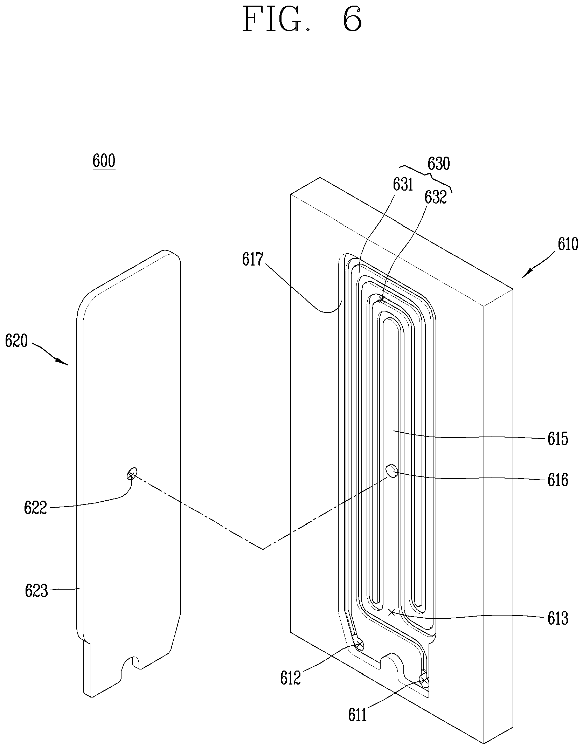

In a practical example illustrated in FIG. 6, the cooling flow-path portion 630 may be formed in the coolant accommodation portion 613. The coolant flowing into the coolant accommodation portion 613, after flowing along the cooling flow-path portion 630, flows out of the cooling main body 610 through the outlet port 612. As described above, the coolant exchanges heat with the IGBT 330 while flowing along the cooling flow-path portion 630.

In the above-mentioned practical example, the support protrusion 615 may be formed in the coolant accommodation portion 613. The support protrusion 615 is configured in such a manner as to support the cooling cover 620 coupled to the cooling main body 610.

The support protrusion 615 may be formed in such a manner as to extend in a direction in which the cooling main body 610 extends, that is, in the upward-downward direction in the practical example illustrated. The support protrusion 615 may be arranged in such a manner as to pass through the center in the leftward-rightward direction of the coolant accommodation portion 613.

When the cooling cover 620 is coupled to the cooling main body 610, the support protrusion 615 is brought into contact with a surface of one side of the cooling cover 620 is directed toward the cooling main body 610. Accordingly, the cooling cover 620 does not deviate from a preset position and thus is not inserted into the coolant accommodation portion 613.

In the above-mentioned practical example, the coupling protrusion 616 is formed on the support protrusion 615 in a manner that protrudes therefrom. The coupling protrusion 616 is coupled to a coupling through-hole 621 formed in the cooling cover 620 by being inserted thereinto. Accordingly, the cooling cover 620 may be accurately arranged at a position for covering the coolant accommodation portion 613.

In the practical example illustrated, the coupling protrusion 616 is positioned at a center portion of the support protrusion 615. In a practical example, the coupling protrusion 616 and the support protrusion 615 may be concentrically arranged. In addition, in the practical example illustrated, the coupling protrusion 616 is formed in the shape of a cylinder having a circular cross section.

A position and a shape of the coupling protrusion 616 may vary according to a position and a shape, respectively, of a coupling through-hole 622.

The cover coupling portion 617 is a portion of the cooling main body 610, with which the cooling cover 620 coupled to the cooling main body 610 is brought into contact. Specifically, when the cooling cover 620 is coupled to the cooling main body 610, the cover coupling portion 617 is brought into contact with a main-body coupling portion 623.

The cover coupling portion 617 may be defined as a surface surrounding the coolant accommodation portion 613. That is, the cover coupling portion 617 are two pairs of surfaces facing each other with the coolant accommodation portion 613 in between. In other words, the cover coupling portion 617 may be defined as an inner circumferential surface of the cooling main body 610.

In the practical example illustrated, the cover coupling portion 617 is formed in such a manner as to surround the coolant accommodation portion 613 from the upper side, the lower side, the front side, and the right side. A space of the cover coupling portion 617 may vary according to shapes of the coolant accommodation portion 613 and the main-body coupling portion 623.

After the cover coupling portion 617 and the main-body coupling portion 623 are brought into contact with each other, the cooling main body 610 and the cooling cover 620 of the cooling plate 600 according to the present disclosure may be coupled to each other using a friction stir welding technique. This coupling will be described in detail below.

Each corner of the cover coupling portion 617 may be beveled. That is, the corners where edges of the cover coupling portion 617 meet may be formed in such a manner as to be rounded. Accordingly, the coolant may smoothly flow inside the coolant accommodation portion 613.

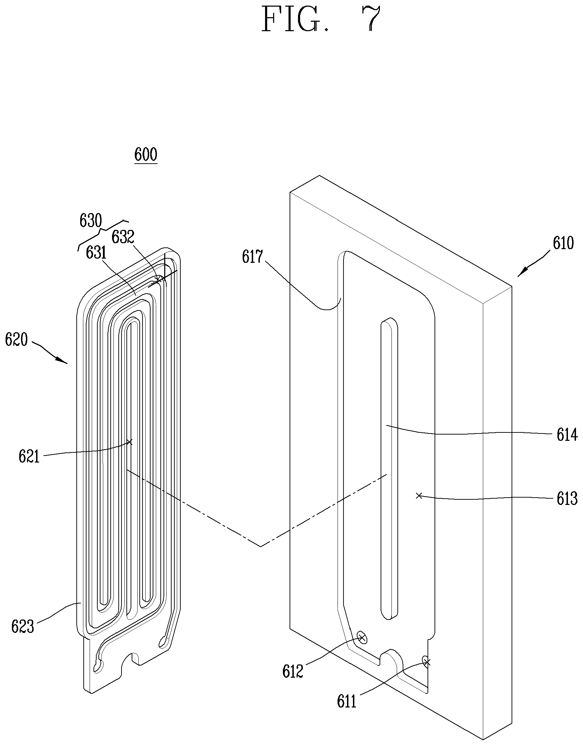

In a practical example illustrated in FIG. 7, the cooling flow-path portion 630 is formed in the cooling cover 620. Accordingly, the cooling main body 610 in the present practical example is different from the cooling main body 610 in the above-mentioned practical example.

Specifically, instead of the support protrusion 615 and the coupling protrusion 616, the cooling main body 610 in the present practical example includes the insertion protrusion 614.

The inlet port 611, the outlet port 612, and the cover coupling portion 617 each have the same structure and function as in the above-mentioned practical example, and thus the insertion protrusion 614 is described below in a focused manner.

The insertion protrusion 614 is coupled to the cooling cover 620 that is coupled to the cooling main body 610 in such a manner as to cover the coolant accommodation portion 613. Accordingly, the cooling main body 610 and the cooling cover 620 may be stably coupled to each other.

When the cooling cover 620 is coupled to the cooling main body 610, the insertion protrusion 614 is brought into contact with a surface of one side of the cooling cover 620 that is directed toward the cooling main body 610. The coupling through-hole 621 is formed in a center portion of the cooling flow-path portion 630 on the surface of the one side of the cooling cover 620 in a manner that passes therethrough. The insertion protrusion 614 is inserted into the coupling through-hole 621 in a manner that passes therethrough.

Accordingly, the cooling cover 620 may be coupled to the cooling main body 610 in such a manner as to seal up the coolant accommodation portion 613.

The insertion protrusion 614 may be formed in such a manner as to extend in a direction in which the cooling main body 610 extends, that is, in the upward-downward direction in the practical example illustrated. The insertion protrusion 614 may be arranged in such a manner as to pass through the center in the leftward-rightward direction of the coolant accommodation portion 613.

A position and a shape of the insertion protrusion 614 may vary according to a position and a shape, respectively, of the coupling through-hole 621.

The cooling cover 620 is coupled to the cooling main body 610 in such a manner as to cover the coolant accommodation portion 613. The cooling cover 620 is configured in such a manner as to seal up one side of the coolant accommodation portion 613 that is directed toward the cooling cover 620.

The cooling cover 620 may be coupled to the cooling main body 610 by being fixed thereto. In the cooling plate 600 according to the first embodiment of the present disclosure, the cooling cover 620 is coupled to the cooling main body 610 using the friction stir welding technique. This coupling will be described in detail below.

The cooling cover 620 may be formed in such a manner as to have a cross section of a shape corresponding to the coolant accommodation portion 613. In the practical example illustrated, the coolant accommodation portion 613 is formed in such a manner that a length in the upward-downward direction thereof is greater than a length in the forward-backward direction thereof. Accordingly, the cooling cover 620 may also be formed in such a manner that a length in the upward-downward direction thereof is greater than a length in the forward-backward direction thereof.

The cooling cover 620 may be formed in the shape of a plate. When the cooling cover 620 is coupled to the cooling main body 610 in such a manner as to cover the coolant accommodation portion 613, an outer surface of the cooling cover 620 and an outer surface of the cooling main body 610 may be positioned on the same plane.

The cooling cover 620 includes the coupling through-hole 621, the coupling through-hole 622, and the main-body coupling portion 623.

In the practical example illustrated in FIG. 6, the cooling flow-path portion 630 is formed in the cooling main body 610. In the present practical example, the cooling cover 620 includes the coupling through-hole 622 and the main-body coupling portion 623.

The coupling through-hole 622 is formed in the cooling cover 620 in a manner that passes therethrough. When the cooling cover 620 is coupled to the cooling main body 610, the coupling protrusion 616 is inserted into the coupling through-hole 622 in a manner that passes therethrough. Accordingly, the cooling cover 620 and the cooling main body 610 may be coupled to each other in the precise direction.

The coupling through-hole 622 may be sealed up by the coupling protrusion 616. Accordingly, the coolant flowing in the coolant accommodation portion 613 is prevented from arbitrarily flowing to the outside.

In the practical exampled illustrated, the coupling through-hole 622 is positioned in a center portion of the cooling cover 620. In addition, the coupling through-hole 622 may be formed in such a manner as to have a circular cross section. A position and a shape of the coupling through-hole 622 may vary according to a position and a shape, respectively, of the coupling protrusion 616.

The main-body coupling portion 623 may be a portion of the cooling cover 620 that is brought into contact with the cooling main body 610. Specifically, when the cooling cover 620 is coupled to the cooling main body 610, the main-body coupling portion 623 is brought into contact with the cover coupling portion 617.

The main-body coupling portion 623 may be defined as an outer circumferential surface of the cooling cover 620. That is, the main-body coupling portion 623 is two pairs of surfaces facing each other from the outermost edges, respectively, of the cooling cover 620.

In the practical example illustrated, the main-body coupling portion 623 may be defined as surfaces positioned to the upper side, the lower side, the front side, and the right side, respectively, of the cooling cover 620.

After the cover coupling portion 617 and the main-body coupling portion 623 are brought into contact with each other, the cooling main body 610 and the cooling cover 620 of the cooling plate 600 according to the present disclosure may be coupled to each other using the friction stir welding technique. This coupling will be described in detail below.

Each corner of the main-body coupling portion 623 may be beveled. That is, the corners where edges of the main-body coupling portion 623 meet may be formed in such a manner as to be rounded. A shape of the main-body coupling portion 623 may vary according to a shape of the cover coupling portion 617.

In the practical example illustrated in FIG. 7, the cooling flow-path portion 630 is formed in the cooling cover 620. The cooling cover 620 in the present practical example is different from the cooling main body 610 in the above-mentioned practical example.

Specifically, instead of the coupling through-hole 622, the cooling cover 620 in the present practical example includes the coupling through-hole 621.

The main-body coupling portion 623 has the same structure and function as in the above-mentioned practical example, and the coupling through-hole 621 is described below in a focused manner.

The coupling through-hole 621 is formed in the cooling cover 620 in a manner that passes therethrough. When the cooling cover 620 is coupled to the cooling main body 610, the insertion protrusion 614 is coupled to the coupling through-hole 621 by being inserted thereinto.

The insertion protrusion 614 may be coupled to the coupling through-hole 621 by being inserted thereinto, in such a manner as to seal up the coupling through-hole 621. Accordingly, by sealing up the coolant accommodation portion 613, the coolant flowing in the coolant accommodation portion 613 is prevented from arbitrarily flowing to the outside.

In the practical example illustrated, the coupling through-hole 621 is formed in such a manner as to extend in a direction in which the cooling cover 620 extends, that is, in the upward-downward direction. In addition, the coupling through-hole 621 is positioned in such a manner as to pass through a center portion in the forward-backward direction of the cooling cover 620. A position and a shape of the coupling through-hole 621 may vary according to a position and a shape, respectively, of the insertion protrusion 614.

The cooling flow-path portion 630 is a flow path along which the coolant flows after flowing into the coolant accommodation portion 613. The coolant flowing from the outside through the inlet port 611 flows in the coolant accommodation portion 613 along the cooling flow-path portion 630 and then flows to the outside through the outlet port 612.

The cooling flow-path portion 630 communicates with the inlet port 611. The coolant flowing from the outside through the inlet port 611 may flow along the cooling flow-path portion 630.

The cooling flow-path portion 630 communicates with the outlet port 612. The coolant flowing along the cooling flow-path portion 630 may flow to the outside through the outlet port 612.

The cooling flow-path portion 630 may be formed in the cooling main body 610 or the cooling cover 620. This coupling will be described in detail below.

The cooling flow-path portion 630 includes a flow-path protrusion 631 or a flow-path recess 632.

The flow-path protrusion 631 functions as a wall portion for forming a cooling flow path. A plurality of flow-path protrusions 631 may be formed. The plurality of flow-path protrusions 631 are arranged to be spaced apart.

A space where the plurality of flow-path protrusions 631 are formed in such a manner as to be spaced apart may be defined as the flow-path recess 632. The coolant flowing into the coolant accommodation portion 613 may be guided by the flow-path protrusion 631 and may flow along the flow-path recess 632.

The plurality of flow-path protrusions 631 may be continuous. That is, the plurality of flow-path protrusions 631 can be understood as being formed by a single flow-path protrusion 631 reciprocating in the upward-downward direction and the forward-backward direction of the coolant accommodation portion 613.

An end portion of one side of the flow-path protrusion 631 may be positioned adjacent to the inlet port 611. The coolant flowing into the coolant accommodation portion 613 through the inlet port 611 may be guided in flowing into the flow-path recess 632 along the flow-path protrusion 631.

An end portion of the other side of the flow-path protrusion 631 may be positioned adjacent to the outlet port 612. The coolant flowing in the coolant accommodation portion 613 along the flow-path recess 632 may be guided to the outlet port 612.

A space where the flow-path protrusions 631 are formed in such a manner as to be spaced apart may be defined as the flow-path recess 632. The flow-path recess 632 is a space where the coolant flowing from the outside flows. The flow-path recess 632 may be formed in such a manner as to surround the flow-path protrusion 631, and the coolant flowing in the flow-path recess 632 may be guided by the flow-path protrusion 631.

The flow-path recess 632 communicates with the inlet port 611. The coolant flowing from the outside through the inlet port 611 may flow in the flow-path recess 632 and may flow inside the coolant accommodation portion 613.

The flow-path recess 632 communicates with the outlet port 612. After flowing in the flow-path recess 632, the coolant may flow out of the cooling plate 600 through the outlet port 612.

The flow-path recess 632 may be continuously formed. That is, the flow-path recess 632 may communicate with the inlet port 611 and the outlet port 612 inside the coolant accommodation portion 613.

In the practical example illustrated, the flow-path protrusion 631 may be formed in such a manner as to extend in the upward-downward direction of the coolant accommodation portion 613 in a zigzag fashion. Accordingly, the flow-path recess 632 that is formed between each of the flow-path protrusions 631 is also formed in such a manner as to extend in the upward-downward direction of the coolant accommodation portion 613 in a zigzag fashion.

The flow-path protrusion 631 and the flow-path recess 632 may be formed in such a manner as to have such an arbitrary shape that the coolant may exchange heat with the IGBT 330 while flowing therein.

In the practical example illustrated in FIG. 6, the cooling flow-path portion 630 is formed in the cooling main body 610. In the above-mentioned practical example, the flow-path protrusion 631 is formed on a surface formed by recessing the coolant accommodation portion 613, in a manner that extends therefrom over a predetermined distance.

In other words, the flow-path protrusion 631 is formed on one surface of the cooling main body 610 facing the cooling cover 620 and forming the coolant accommodation portion 613 in a manner that protrudes therefrom. The flow-path recess 632 is formed by a space that is formed between each of the flow-path protrusions 631.

In another practical example, the flow-path recess 632 may be formed by recessing one surface of the cooling main body 610 facing the cooling cover 620 and forming the coolant accommodation portion 613. In the above-mentioned practical example, the flow-path protrusion 631 may be defined as a protrusion that is formed between each of the flow-path recesses 632.

In this case, the support protrusion 615 and the coupling protrusion 616 are positioned inside the cooling flow-path portion 630, that is, in a center portion of the cooling main body 610. In addition, an end portion of the flow-path protrusion 631 that faces the cooling cover 620 may be brought into contact with one surface of the cooling cover 620 that is directed toward the coolant accommodation portion 613.

In the practical example illustrated in FIG. 7, the cooling flow-path portion 630 is formed in the cooling cover 620. In the above-mentioned practical example, the flow-path protrusion 631 is formed on one surface of the cooling cover 620 that is directed toward the cooling main body 610, in a manner that protrudes therefrom. The flow-path recess 632 is formed by a space that is formed between each of the flow-path protrusions 631.

In another practical example, the flow-path recess 632 may be formed in one surface of the cooling cover 620 that is directed toward the cooling main body 610, in a manner that protrudes therefrom. In the above-mentioned practical example, the flow-path protrusion 631 may be defined as a protrusion that is formed between each of the flow-path recesses 632.

In this case, the coupling through-hole 621 is positioned inside the cooling flow-path portion 630, that is, in a center portion of the cooling cover 620. In addition, an end portion of the flow-path protrusion 631 that is directed toward the cooling main body 610 may face the cooling cover 620 and may be brought into contact with one surface of the cooling main body 610 that surrounds the coolant accommodation portion 613.

The separation portion 640 is a space that is formed between the cooling main body 610 or a surface of one side of the cooling cover 620 and an end portion of the flow-path protrusion 631 when the cooling main body 610 and the cooling cover 620 are coupled to each other,

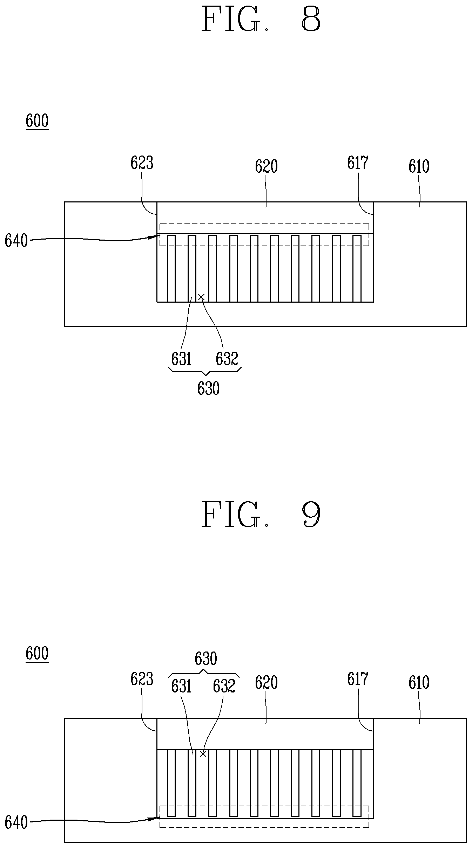

In a practical example illustrated in FIG. 8, the cooling flow-path portion 630 is formed in the cooling main body 610. In the above-mentioned practical example, the separation portion 640 may be defined as a space between an end portion of the flow-path protrusion 631 that is directed toward the cooling cover 620, and a surface of one side of the cooling cover 620 that is directed toward the coolant accommodation portion 613.

In a practical example illustrated in FIG. 9, the cooling flow-path portion 630 is formed in the cooling cover 620. In the above-mentioned practical example, the separation portion 640 may be defined as a space between an end portion of the flow-path protrusion 631 that is directed toward the cooling main body 610, and a surface of one side of the cooling main body 610 that is directed toward the cooling cover 620.

For ease of understanding, the separation portion 640 is also described as being included in the cooling plate 600. However, in a case where the separation portion 640 is formed, there is a concern that the coolant flowing into the coolant accommodation portion 613 will not flow along the cooling flow-path portion 630.

That is, a situation may occur where the coolant does not smoothly flow along a flow path including the inlet port 611, the cooling flow-path portion 630, and the outlet port 612 and where some amount of coolant remains in the separation portion 640.

Therefore, it is desirable that the separation portion 640 is not generated in order for the coolant to smoothly flow inside the cooling plate 600.

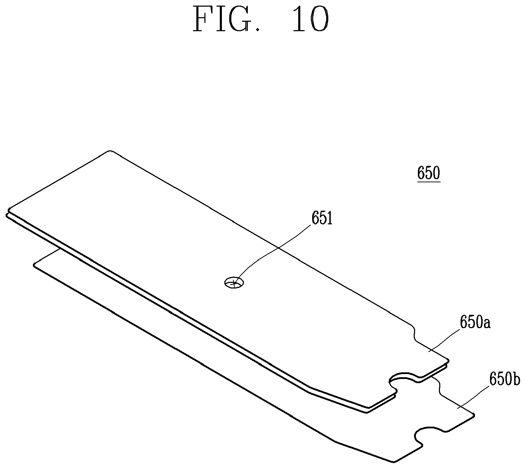

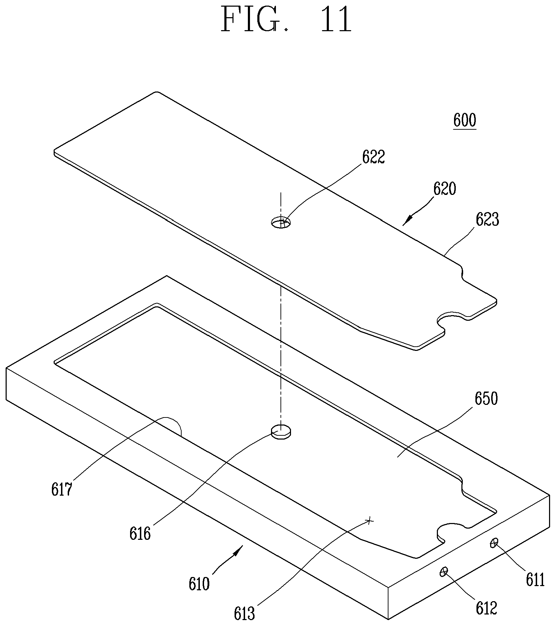

Accordingly, with reference to FIGS. 10 and 11, the cooling plate 600 according to the first embodiment of the present disclosure includes the seat member 650 in order to prevent formation of the separation portion 640.

The seat member 650 is configured in such a manner as to be positioned in the separation portion 640 and thus to fill the separation portion 640. An end portion of the flow-path protrusion 631 is kept in contact with the cooling main body 610 or the cooling cover 620, thereby preventing arbitrary remaining of the coolant.

The seat member 650 may be accommodated in the coolant accommodation portion 613. An outer circumferential surface of the seat member 650 accommodated in the coolant accommodation portion 613 may be brought into contact with the cover coupling portion 617.

In practical examples illustrated in FIGS. 6 and 8, the seat member 650 is positioned between an end portion of the flow-path protrusion 631 that is directed toward the cooling cover 620 and one surface of the cooling cover 620 that is directed toward the coolant accommodation portion 613.

That is, before the cooling cover 620 is coupled to the cooling main body 610 in such a manner as to cover the coolant accommodation portion 613, the seat member 650 is accommodated in the coolant accommodation portion 613 in such a manner as to cover the flow-path protrusion 631.

In practical examples in FIGS. 7 and 9, the seat member 650 is positioned between an end portion of the flow-path protrusion 631 that is directed toward the coolant accommodation portion 613 and a surface of one side of the cooling main body 610 facing the cooling cover 620 and forming the coolant accommodation portion 613.

That is, before the cooling cover 620 is coupled to the cooling main body 610 in such a manner as to cover the coolant accommodation portion 613, the seat member 650 is accommodated in the coolant accommodation portion 613 in such a manner as to cover one surface facing the cooling cover 620 and forming the coolant accommodation portion 613.

The seat member 650 accommodated in the coolant accommodation portion 613 is melted and thus is coupled to the end portion of the flow-path protrusion 631. In a practical example, the seat member 650 may be melted using a gas shielded brazing technique. Accordingly, the separation portion 640 may be filled.

The seat member 650 is melted using the gas shielded brazing technique and thus may be formed of an arbitrary material that is capable of joining different members to each other.

The seat member 650 may be formed in such a manner as to have a shape corresponding to a shape of the coolant accommodation portion 613. In the practical example illustrated, the coolant accommodation portion 613 is formed in such a manner that a length the upward-downward direction thereof is greater than a length in the forward-backward direction thereof.

Accordingly, the seat member 650 is formed in such a manner that a length in the upward-downward direction thereof is greater than a length in the forward-backward direction thereof.

A plurality of seat members 650 may be provided. In a practical example illustrated in FIG. 10, the seat member 650 includes a first seat member 650a and a second seat member 650b. In a case where the plurality of seat members 650 are provided, the separation portion 640 may be filled more effectively.

The plurality of seat members 650 may be formed in such a manner as to have different thicknesses. In the practical example illustrated in FIG. 10, the first seat member 650a is formed in such a manner as to have a greater thickness than the second seat member 650b.

A seat through-hole 651 is formed in the seat member 650 in a manner that passes therethrough. The coupling protrusion 616 of the cooling main body 610 is inserted into the seat through-hole 651 in a manner that passes therethrough.

In the practical example illustrated, the seat through-hole 651 has a circular cross section and is positioned in a center portion of the seat member 650. A position and a shape of the seat through-hole 651 may vary according to a position and a shape, respectively, of the coupling protrusion 616.

After the seat member 650 is melted, the cooling cover 620 is coupled to the cooling main body 610 in such a manner to cover the coolant accommodation portion 613. Corners where edges of the cover coupling portion 617 and the main-body coupling portion 623 meet may be coupled to each other using the friction stir welding technique.

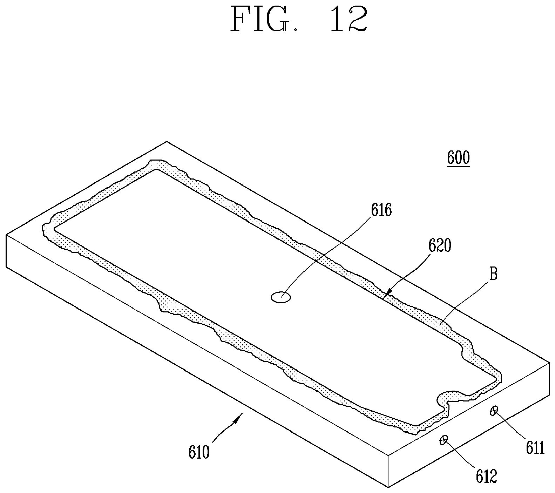

Accordingly, as illustrated in FIG. 12, a bead may be generated at each of the corners where the edges of the cover coupling portion 617 and the main-body coupling portion 623 meet. The beads may be removed by performing a milling operation or the like.

### 5. Description of a Method of Manufacturing a Cooling Plate 600 according to a Second Embodiment of the Present Disclosure

The cooling plate 600 according to the first embodiment of the present disclosure may be formed using the friction stir welding (FSW) technique.

With friction stir welding, the cooling main body 610, which is a basic material, and the cooling cover 620 themselves are melted and thus are coupled to each other. Therefore, with the friction stir welding, the cooling main body 610 and the cooling cover 620 may be coupled to each other without a material for welding that is different from materials of the cooling main body 610 and the cooling cover 620.

In addition, with the friction stir welding, the cooling main body 610 and the cooling cover 620 may be coupled to each other in such a manner as to be sealed up without using a material for sealing-up, such as an O-ring. Therefore, a situation where the blocking of the cooling flow-path portion 630 by the member for sealing-up or the damage to or wearing of the member for sealing-up causes the coolant to flow to the outside does not occur.

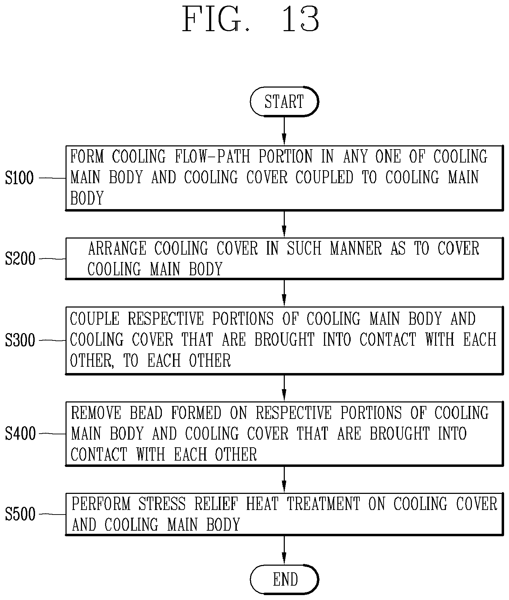

The method of manufacturing a cooling plate 600 according to the second embodiment will be described in detail below with reference to FIGS. 13 to 16.

In a practical example illustrated in FIG. 13, a method of manufacturing a cooling plate 600 includes: Step S100 of forming a cooling flow-path portion 630 in any one of a cooling main body 610 and a cooling cover 620 coupled to the cooling main body 610; Step S200 of arranging the cooling cover 620 in such a manner as to cover the cooling main body 610; Step S300 of coupling respective portions of the cooling main body 610 and the cooling cover 620 to each other, the respective portions being brought into contact with each other; Step S400 of removing a bead formed on the portions of the cooling main body 610 and the cooling cover 620, the respective portions being brought into contact with each other; and Step S500 of performing stress relief heat treatment on the cooling cover 620 and the cooling main body 610.

### (1) Description of Step S100 of Forming Cooling Flow-path Portion 630 in Any One of the Cooling Main Body 610 and the Cooling Cover 620 Coupled to the Cooling Main Body 610

In Step S100, the cooling flow-path portion 630 is formed in any one of respective surfaces of the cooling main body 610 and the cooling cover 620 that face each other.

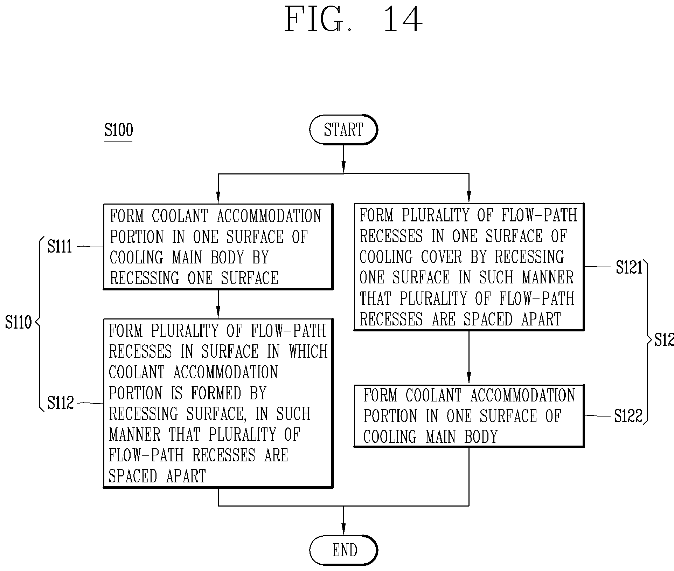

Step S100 will be described in detail below with reference to FIG. 14.

As described above, in the cooling plate 600 according to the second embodiment of the present disclosure, the cooling flow-path portion 630 may be formed in any one of the cooling main body 610 and the cooling cover 620.

First, Step S110 of forming the cooling flow-path portion 630 in the cooling main body 610 is described.

A coolant accommodation portion 613 is formed by recessing one surface of the cooling main body 610 that is directed toward the cooling cover 620, by a predetermined distance therefrom (S111). The predetermined distance by which the one surface of the cooling main body 610 is recessed to form the coolant accommodation portion 613 is greater than a distance by which the flow-path protrusion 631 of the cooling flow-path portion 630 protrudes.

According, when the cooling cover 620 is coupled to the cooling main body 610 in such a manner as to the coolant accommodation portion 613, an outer surface of the cooling main body 610 and an outer surface of the cooling cover 620 may be positioned on the same plane.

In addition, a plurality of flow-path recesses 632 are formed by recessing a surface of the cooling main body 610 in which the coolant accommodation portion 613 is formed by recessing, by a predetermined therefrom (S112). The plurality of flow-path recesses 632 communicate with each other.

The plurality of flow-path recesses 632 may be arranged to be spaced apart. A plurality of flow-path protrusions 631 may be defined by partition walls that are formed by arranging the plurality of flow-path recesses 632 to be spaced apart.

In other words, the plurality of flow-path protrusions 631 are formed on the surface of the cooling main body 610 in which the coolant accommodation portion 613 is formed by recessing, in a manner that protrudes over a predetermined distance therefrom. The plurality of flow-path protrusions 631 may be continuous.

The plurality of flow-path protrusions 631 may be arranged to be spaced apart. The plurality of flow-path protrusions 631 may be defined by spaces that are formed by arranging the plurality of flow-path protrusions 631 to be spaced apart.

Next, Step S120 of forming the cooling flow-path portion 630 in the cooling cover 620 is described.

The plurality of flow-path recesses 632 are formed by recessing one surface of the cooling cover 620 that is directed toward the cooling main body 610, by a predetermined distance therefrom (S121). The plurality of flow-path recesses 632 communicate with each other.

The plurality of flow-path recesses 632 may be arranged to be spaced apart. A plurality of flow-path protrusions 631 may be defined by the partition walls that are formed by arranging the plurality of flow-path recesses 632 to be spaced apart.

In other words, the plurality of flow-path protrusions 631 are formed on one surface of the cooling cover 620 that is directed toward the cooling main body 610, in a manner that protrudes over a predetermined distance therefrom. The plurality of flow-path protrusions 631 may be continuous.

The plurality of flow-path protrusions 631 may be arranged to be spaced apart. The plurality of flow-path protrusions 631 may be defined by the spaces that are formed by arranging the plurality of flow-path protrusions 631 to be spaced apart.

In addition, the coolant accommodation portion 613 is formed by recessing one surface of the cooling main body 610 that is directed toward the cooling cover 620, by a predetermined distance (S122). The predetermined distance by which the one surface of the cooling main body 610 is recessed to form the coolant accommodation portion 613 is greater than the distance by which the flow-path protrusion 631 of the cooling flow-path portion 630 protrudes.

According, when the cooling cover 620 is coupled to the cooling main body 610 in such a manner as to cover the coolant accommodation portion 613, an outer surface of the cooling main body 610 and an outer surface of the cooling cover 620 may be positioned on the same plane.

The order of Step S121 of forming the plurality of flow-path recesses 632 by the recessing by the predetermined distance and Step S122 of forming the coolant accommodation portion 613 by the recessing by the predetermined distance may be changed.

### (2) Description of Step S200 of Arranging the Cooling Cover 620 in Such a Manner as to Cover the Cooling Main Body 610

In Step S200, the cooling main body 610 is arranged in the cooling main body 610 in such a manner as to cover the coolant accommodation portion 613 formed in the cooling cover 620.

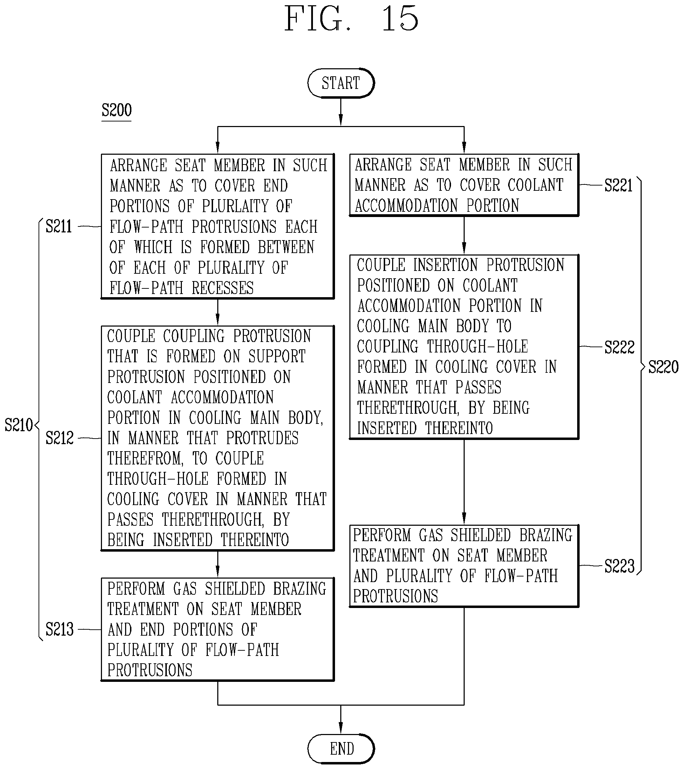

Step S200 will be described in detail below with reference to FIG. 15.

As described above, a separation portion 640 may be formed between an end portion of the flow-path protrusion 631 and the cooling main body 610 or between an end portion of the flow-path protrusion 631 and the cooling cover 620.

Therefore, it is desirable that an operation for filling the separation portion 640 is performed in advance in order for a coolant to flow smoothly.

First, Step S210 of arranging the cooling cover 620 in such a manner as to cover the cooling main body 610 in a case where the cooling flow-path portion 630 is formed in the cooling main body 610 is described.

A seat member 650 is arranged in such a manner as to cover the plurality of flow-path protrusions 631 (S211). As described above, the plurality of flow-path protrusions 631 are defined by the partition walls that are formed between each of the plurality of flow-path recesses 632 that are formed by the recessing.

Since the plurality of flow-path protrusions 631 are formed in such a manner as to protrude toward the cooling cover 620, the seat member 650 is arranged in such a manner as to cover end portions of the plurality of flow-path protrusions 631 that are directed toward the cooling cover 620.

In this case, the seat member 650 is formed in such a manner as to have a shape corresponding to the coolant accommodation portion 613. Accordingly, when the seat member 650 is accommodated in the coolant accommodation portion 613, an outer circumferential surface of the seat member 650 is brought into contact with the cover coupling portion 617.

After the seat member 650 is arranged, the cooling cover 620 is arranged on the cooling main body 610 in such a manner as to cover the coolant accommodation portion 613 and the seat member 650 (S212). At this point, a coupling protrusion 616 formed on a support protrusion 615 of the cooling main body 610 in a manner that protrudes therefrom toward the cooling cover 620 is coupled to a coupling through-hole 622 formed in the cooling cover 620 in a manner that passes therethrough.

In addition, a main-body coupling portion 623 of the cooling cover 620 accommodated in the coolant accommodation portion 613 is brought into contact with the cover coupling portion 617 of the cooling main body 610. A surface of one side of the cooling cover 620 that is directed toward the coolant accommodation portion 613 may be brought into contact with the seat member 650.

The seat member 650 brought into contact with an and portion of the flow-path protrusion 631 is melted, and thus the seat member 650 and an end portion of the flow-path protrusion 631 are coupled to each other (S213). The melting may be performed using the gas shielded brazing technique.

Accordingly, the separation portion 640 formed between the end portion of the flow-path protrusion 631 and the cooling cover 620 may be filled..

Although not illustrated, the seat member 650 may also be coupled to one surface of the cooling cover 620 that is directed toward the coolant accommodation portion 613. The coupling may also be achieved through gas shielded brazing treatment.

Next, Step S220 of arranging the cooling cover 620 in such a manner as to cover the cooling main body 610 in a case where the cooling flow-path portion 630 is formed in the cooling cover 620 is described.

The seat member 650 is arranged in such a manner as to cover the coolant accommodation portion 613 (S221). Specifically, the seat member 650 is arranged to cover one surface directed toward the cooling cover 620 and forming the coolant accommodation portion 613.

When the seat member 650 is arranged in such a manner as to cover the coolant accommodation portion 613, an outer circumferential surface of the seat member 650 is brought into contact with the cover coupling portion 617.

After the seat member 650 is arranged, the cooling cover 620 is arranged on the cooling main body 610 in such a manner as to cover the coolant accommodation portion 613 and the seat member 650 (S222). At this point, the insertion protrusion 614 positioned in the coolant accommodation portion 613 in the cooling main body 610 is coupled to the coupling through-hole 621 formed in the cooling cover 620 in a manner that passes therethrough, by being inserted thereinto. Accordingly, the coupling through-hole 621 is sealed up.

In addition, the main-body coupling portion 623 of the cooling cover 620 accommodated in the coolant accommodation portion 613 is brought into contact with the cover coupling portion 617 of the cooling main body 610. An end portion of the flow-path protrusion 631 that is directed toward the coolant accommodation portion 613 may be brought into contact with the seat member 650.

The seat member 650 brought into contact with the end portion of the flow-path protrusion 631 is melted, and thus the seat member 650 and the end portion of the flow-path protrusion 631 is coupled to each other (S223). The melting may be performed using the gas shielded brazing technique.

Accordingly, the separation portion 640 formed between the end portion of the flow-path protrusion 631 and the cooling main body 610 may be filled.

Although not illustrated, the seat member 650 may also be coupled to one surface directed toward the cooling cover 620 and forming the coolant accommodation portion 613. The coupling may also be achieved through the gas shielded brazing treatment.

### (3) Description of Step S300 of Respective Portions of the Cooling Main Body 610 and the Cooling Cover 620 that Are Brought into Contact with Each Other

In Step S300, the cooling main body 610 and the cooling cover 620 are coupled to each other using the friction stir welding technique. As described above, for the friction stir welding, a separate metal material for coupling the cooling main body 610 and the cooling cover 620 is not necessary.

That is, with the friction stir welding, the cooling main body 610 and the cooling cover 620 themselves may be melted, and thus the cooling main body 610 and the cooling cover 620 may be coupled to each other.

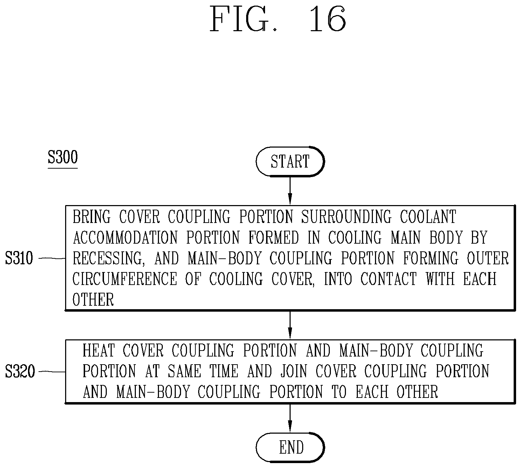

Step S300 will be described in detail below with reference to FIG. 16.

As described above, the cooling cover 620 is arranged in such a manner as to cover the coolant accommodation portion 613 and the seat member 650.

Accordingly, the main-body coupling portion 623 of the cooling cover 620 and the cover coupling portion 617 of the cooling main body 610 are brought into contact with each other (S310). As described above, the cooling cover 620 may be formed in such a manner as to have the same shape than the coolant accommodation portion 613.

Therefore, the cooling cover 620 is coupled to the coolant accommodation portion 613 by being inserted thereinto, and thus the main-body coupling portion 623 and the cover coupling portion 617 may be stably kept in contact with each other.

At this point, an outer surface of the cooling main body 610 and an outer surface of the cooling cover 620 may be arranged in such a manner as to be positioned on the same plane.

Next, the cover coupling portion 617 and the main-body coupling portion 623 are heated at the same time and thus are joined to each other (S320). Specifically, respective corners of the cover coupling portion 617 and the main-body coupling portion 623 that are brought into contact with each other are melted at the same time using the friction stir welding and thus are joined to each other. Accordingly, the coolant accommodation portion 613 may be sealed up by the cooling cover 620.

This process may be continuously performed on each of the corners where edges of the cover coupling portion 617 and the main-body coupling portion 623.

In addition, although not illustrated, the coupling protrusion 616 and the coupling through-hole 622 into which the coupling protrusion 616 is inserted for being coupled thereto may also be melted at the same time for being joined to each other.

Likewise, the insertion protrusion 614 and the coupling through-hole 621 into which the insertion protrusion 614 is inserted for being coupled thereto may also be melted at the same time using the friction stir welding technique for being joined to each other.

### (4) Description of Step S400 of removing Beads formed on the Respective Portions of the Cooling Main Body 610 and the Cooling Cover 620 that are Brought into Contact with Each Other

In Step S400, the cover coupling portion 617 of the cooling main body 610 and the main-body coupling portion 623 of the cooling cover 620 are joined to each other using the friction stir welding technique, and thus the formed beads are removed.

With reference back to FIG. 12, the beads are formed on respective borders of the cover coupling portion 617 and the main-body coupling portion 623 are melted using the friction stir welding technique and thus are joined to each other. With the beads, portions in the vicinity of the respective border of the cover coupling portion 617 and the main-body coupling portion 623 protrude when compared with other portions.

Accordingly, in Step S400, an operation of removing the beads is performed. In a practical example, a machining operation for milling treatment may be performed on the beads, and thus the beads may be removed.

As described above, the coupling protrusion 616 and the coupling through-hole 622 may also be melted and joined to each other using the friction stir welding technique. Accordingly, the machining operation for milling treatment may be performed on the outer circumferential vicinity of the coupling protrusion 616 and the inner circumferential vicinity of the coupling through-hole 622, and thus the formed beads may be removed.

In addition, as described above, the insertion protrusion 614 and the coupling through-hole 621 may also be melted and joined to each other using the friction stir welding technique. Accordingly, the machining operation for milling treatment may be performed in the outer circumferential vicinity of the insertion protrusion 614 and the inner circumferential vicinity of the coupling through-hole 621, and thus the formed beads many be removed.

### (5) Description of Step S500 of Performing Stress Relief Heat Treatment on the Cooling Cover 620 and the Cooling Main Body 610

In Step S500, heat treatment is performed on the cooling main body 610 and the cooling cover 620 that are coupled to each other using the friction stir welding technique, and thus stress that may occur due to the coupling is relieved.

Thermal stress due to high temperature may remain in the cover coupling portion 617 and the main-body coupling portion 623 that are melted and joined to each other using the friction stir welding technique.

In addition, as described above, the coupling protrusion 616 and the coupling through-hole 622, or the insertion protrusion 614 or the coupling through-hole 621 may be melted and joined to each other using the friction stir welding technique, and thus, thermal stress due to high temperature may remain therein.

Therefore, in Step S500, processing for removing the thermal stress remaining in each coupling portion is performed.

Heat treatment for stress removal may be performed using an arbitrary method for removing thermal stress remaining within a metal material or the like. In a practical example, the heat treatment may be performed using an annealing method.

The desired embodiment of the present embodiment according to the present disclosure is described above. It would be understandable to a person of ordinary skill in the art that various modifications and alterations may be made to the desired embodiment of the present disclosure within the scope of the technical idea of the present disclosure and the scope of the present disclosure that are defined in the following claims.

## Claims

1. A cooling plate comprising:
a cooling main body having a space formed inside;
a cooling cover coupled to the cooling main body in such a manner as to seal up the space; and
a cooling flow-path portion provided in any one of respective surfaces of the cooling cover and the cooling main body that face each other, and forming a flow path along which a coolant flows in the space,
wherein the cooling main body and the cooling cover are coupled to each other by friction stir welding.

2. The cooling plate of claim 1, wherein the cooling main body comprises:
a coolant accommodation portion formed by recessing a surface of one side of the cooling main body that is directed toward the cooling cover, and forming the space; and
an inlet port and an outlet port that are formed in the cooling main body in a manner that passes therethrough, so that the coolant accommodation portion and the outside of the cooling main body communicate with each other.
wherein the inlet port and the outlet port communicate with the coolant accommodation portion.

3. The cooling plate of claim 2, wherein the cooling flow-path portion is provided in the cooling cover,
wherein an insertion protrusion is provided by being formed on the coolant accommodation portion in a manner that protrudes therefrom toward the cooling cover,
wherein a coupling through-hole is provided by being formed in the cooling cover in a manner that passes therethrough, and is configured in such a manner that the insertion protrusion is coupled to the coupling through-hole by being inserted thereinto, and
wherein the insertion protrusion and the coupling through-hole are formed in such a manner as to extend in the same direction.

4. The cooling plate of claim 2, wherein the cooling flow-path portion is provided in the cooling main body,
wherein a support protrusion is provided by being formed on the coolant accommodation portion in a manner that protrudes therefrom toward the cooling cover, and
wherein when the cooling cover is coupled to the coolant accommodation portion, a surface of one side of the cooling cover that is directed toward the coolant accommodation portion is brought into contact with the support protrusion.

5. The cooling plate of claim 4, wherein the cooling main body comprises a coupling protrusion formed on a surface of one side of the support protrusion that is directed toward the cooling cover, in a manner that protrudes therefrom, and
wherein the coupling through-hole is formed in the cooling cover in a manner that passes therethrough, and thus, when the cooling cover is coupled to the cooling main body, the coupling protrusion is coupled to the coupling through-hole by being inserted thereinto.

6. The cooling plate of claim 1, wherein the cooling main body comprises a cover coupling portion surrounding the space, the coupled cooling cover being brought into contact with the cover coupling portion,
wherein the cooling cover comprises a main-body coupling portion forming an outer edge of the cooling cover and brought into contact with the cover coupling portion, and
wherein the cover coupling portion and the main-body coupling portion are heated at the same time and thus is joined to each other.

7. The cooling plate of claim 1, wherein the cooling flow-path portion comprises a flow-path protrusion formed in a manner that protrudes toward the other one of the respective surfaces of the cooling cover and the cooling main body that face each other, and formed in such a manner as to extend in one direction,
wherein a plurality of the flow-path protrusions are provided, and the plurality of the flow-path protrusions are arranged to be spaced apart,
wherein a flow-path recess along which the coolant flows is formed in a space that is formed by arranging the plurality of the flow-path protrusion to be spaced apart, and
wherein an end portion of the flow-path protrusion that is directed toward the other one of the respective surfaces of the cooling cover and the cooling main body that face each other is brought into contact with the other one of the respective surfaces of the cooling cover and the cooling main body that face each other.

8. The cooling plate of claim 7, wherein the end portion of the flow-path protrusion that is directed toward the other one of the respective surfaces of the cooling cover and the cooling main body that face each other is spaced apart a predetermined distance from the other one of the respective surfaces of the cooling cover and the cooling main body that face each other, and
a seat member that is brought into contact with each of the end portion of the flow-path protrusion and the other one of the respective surfaces of the cooling cover and the cooling main body that face each other is provided in a space that is formed by spacing the end portion of the flow-path protrusion apart the predetermined distance.

9. A method of manufacturing a cooling plate, the method comprising:
a step of forming a cooling flow-path portion in any one of a cooling main body and a cooling cover coupled to the cooling main body;
a step of arranging the cooling cover in such a manner as to cover the cooling main body; and
a step of coupling respective portions of the cooling main body and the cooling cover that are brought into contact with each other, to each other,
wherein the cooling main body and the cooling cover are coupled to each other by friction stir welding.

10. The method of claim 9, wherein the step of forming the cooling flow-path portion in any one of the cooling main body and the cooling cover coupled to the cooling main body comprises:
a step of forming a coolant accommodation portion in one surface of the cooling main body by recessing the one surface; and
a step of forming a plurality of flow-path recesses in a surface in which the coolant accommodation portion is formed by recessing the one surface, by recessing the surface in such a manner that the plurality of flow-path recesses are spaced apart, and
wherein the step of arranging the cooling cover in such a manner as to cover the cooling main body comprises:
a step of arranging a seat member in such a manner as to cover end portions of a plurality of flow-path protrusions each of which is formed between each of the plurality of flow-path recesses;
a step of coupling a coupling protrusion formed on a support protrusion positioned on the coolant accommodation portion in the cooling main body in a manner that protrudes therefrom, to a coupling through-hole formed in the cooling cover in a manner that passes therefrom, by being inserted thereinto; and
a step of performing gas shielded brazing treatment on the seat member and the end portions of the plurality of flow-path protrusions.

11. The method of claim 9, wherein the step of forming the cooling flow-path portion in any one of the cooling main body and the cooling cover coupled to the cooling main body comprises:
a step of forming a plurality of flow-path recesses in one surface of the cooling cover by recessing the one surface in such a manner that the plurality of flow-path recesses are spaced apart; and
a step of forming a coolant accommodation portion in one surface of the cooling main body by recessing the one surface, and
wherein the step of arranging the cooling cover in such a manner as to cover the cooling main body comprises:
a step of arranging a seat member in such a manner as to cover the cooling main body;
a step of coupling an insertion protrusion positioned on the coolant accommodation portion in the cooling main body to a coupling through-hole formed in the cooling cover in a manner that passes therethrough, by being inserted thereinto; and
a step of performing gas shielded brazing treatment on the seat member and the end portions of the plurality of flow-path protrusions each of which is formed between each of the plurality of flow-path recesses.

12. The method of claim 9, further comprising: after the step of coupling the respective portions of the cooling main body and the cooling cover that are brought into contact with each other, to each other,
a step of removing a bead formed on respective portions of the cooling main body and the cooling cover that are brought into contact with each other; and
a step of performing stress relief heat treatment on the cooling cover and the cooling main body,
wherein the bead is removed by performing milling treatment thereon, and
wherein the step of coupling the respective portions of the cooling main body and the cooling cover that are brought into contact with each other, to each other, comprises:
a step of bringing a cover coupling portion surrounding a coolant accommodation portion formed in the cooling main body by recessing and a main-body coupling portion forming an outer circumference of the cooling cover into contact with each other; and
a step of heating the cover coupling portion and the main-body coupling portion at the same time and thus joining the cover coupling portion and the main-body coupling portion to each other.
